(19) **Europäisches Patentamt / European Patent Office / Office européen des brevets**

(11) **EP 4 589 932 A1**

(12) **EUROPEAN PATENT APPLICATION**
published in accordance with Art. 153(4) EPC

(43) Date of publication:
23.07.2025 Bulletin 2025/30

(21) Application number: 23868672.9

(22) Date of filing: 22.09.2023

(51) International Patent Classification (IPC):
H04M 1/02 (2006.01)  G06F 1/16 (2006.01)
H03H 7/38 (2006.01)  F16C 11/04 (2006.01)
H05K 1/02 (2006.01)

(52) Cooperative Patent Classification (CPC):
F16C 11/04; G06F 1/16; H03H 7/38; H04M 1/02;
H05K 1/02

(86) International application number:
PCT/KR2023/014578

(87) International publication number:
WO 2024/063621 (28.03.2024 Gazette 2024/13)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 23.09.2022  KR 20220121214
25.10.2022  KR 20220138765

(71) Applicant: Samsung Electronics Co., Ltd.
Suwon-si, Gyeonggi-do 16677 (KR)

(72) Inventors:
• YUN, Himchan
  Suwon-si, Gyeonggi-do 16677 (KR)
• PARK, Sungkoo
  Suwon-si, Gyeonggi-do 16677 (KR)

• LEE, Kyungjae
  Suwon-si, Gyeonggi-do 16677 (KR)
• LEE, Kookjoo
  Suwon-si, Gyeonggi-do 16677 (KR)
• CHOI, Donguk
  Suwon-si, Gyeonggi-do 16677 (KR)
• HWANG, Soonho
  Suwon-si, Gyeonggi-do 16677 (KR)
• KIM, Seunghwan
  Suwon-si, Gyeonggi-do 16677 (KR)
• CHUN, Jaebong
  Suwon-si, Gyeonggi-do 16677 (KR)

(74) Representative: HGF
HGF Limited
1 City Walk
Leeds LS11 9DX (GB)

(54) **ELECTRONIC DEVICE COMPRISING CONNECTION STRUCTURE USED AS SIGNAL TRANSMISSION PATH**

(57) An electronic device according to an embodiment may comprise a first housing, a second housing, a display, a connection structure, and at least one processor. The connection structure may electrically connect a second conductive portion of the first housing to a third conductive portion of the second housing. The connection structure may be electrically connected to a fourth conductive portion of the second housing. The connection structure may be used as a path of a first signal provided from the at least one processor to the fourth conductive portion and/or a path of a second signal provided from the fourth conductive portion to the at least one processor. Various other embodiments may also be possible.

EP 4 589 932 A1

FIG. 3C

## Description

### [Technical Field]

The disclosure relates to an electronic device comprising a connecting structure used as a signal transmission path.

### [Background Art]

An electronic device may transmit or receive a signal via an antenna. A housing of the electronic device may include a conductive portion filled with a conductive material in a portion of the housing. The conductive portion of the housing may operate as an antenna for transmitting and/or receiving a wireless signal. A processor may provide a signal to the conductive portion via a signal transmission path and may receive a signal from the conductive portion via the signal transmission path.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device according to an embodiment may include a first housing, a second housing, a display, a connecting structure, and at least one processor. The first housing may include at least one first printed circuit board (PCB). The second housing may be rotatably connected to the first housing with respect to a folding axis. The display may include a first display area, a second display area, and a third display area. The first display area may be disposed on the first housing. The second display area may be disposed on the second housing. The third display area may be disposed between the first display area and the second display area. The connecting structure may be disposed across the folding axis. The at least one processor may be disposed on the at least one first PCB. The first housing may include a first conductive portion and a second conductive portion. The first conductive portion and the second conductive portion may be disposed at a first periphery of the first housing perpendicular to the folding axis from among peripheries of the first housing. The second housing may include a third conductive portion and a fourth conductive portion. The third conductive portion and the fourth conductive portion may be disposed at a second periphery of the second housing, the second periphery facing the first periphery of the first housing when a first direction of the first display area is opposite to a second direction of the second display area. The connecting structure may electrically connect the second conductive portion and the third conductive portion. The connecting structure may be electrically connected to the fourth conductive portion. The connecting structure may be used as a path for a first signal provided from the at least one processor to the fourth conductive portion. The connecting structure may be used as a path for a second signal provided to the at least one processor from the fourth conductive portion.

An electronic device according to an embodiment may include a housing, a first printed circuit board (PCB), and at least one processor. The housing may include a lateral member and a support member. The lateral member may include a first periphery, a second periphery opposite the first periphery, a third periphery extending from an end of the first periphery to an end of the second periphery, and a fourth periphery opposite the third periphery. The support member may be at least partially spaced apart from the lateral member. The first PCB may be disposed closer to the third periphery from among the first periphery and the third periphery. The at least one processor may be disposed on the first PCB. The lateral member may include a first conductive portion, a second conductive portion, and a third conductive portion. The first conductive portion may extend from a first non-conductive portion in the first periphery to a second non-conductive portion in the first periphery. The second conductive portion may extend from the first non-conductive portion to a third non-conductive portion in the second periphery. The third conductive portion may extend from the third non-conductive portion along a portion of the second periphery. The third conductive portion may be electrically connected to the first conductive portion and the second conductive portion. The third conductive portion may be used as a path for a first signal provided from the at least one processor to the first conductive portion or the second conductive portion. The third conductive portion may be used as a path for a second signal provided from the first conductive portion or the second conductive portion to the at least one processor.

### [Description of the Drawings]

FIG. 1 is a block diagram of an electronic device in a network environment according to an embodiment.
FIG. 2A illustrates an example of an unfolded state of an exemplary electronic device.
FIG. 2B illustrates an example of a folded state of an exemplary electronic device.
FIG. 2C is an exploded view of an exemplary electronic device.
FIG. 3A schematically illustrates an exemplary electronic device.
FIG. 3B illustrates a path for a signal when the electronic device of FIG. 3A communicates via a conductive portion of a first housing.

FIG. 3C illustrates a path for a signal when the electronic device of FIG. 3A communicates via a conductive portion of a second housing.

FIG. 4A is a graph illustrating a radiation characteristic of an antenna including a fourth conductive portion.

FIG. 4B is a graph illustrating a radiation characteristic of an antenna including a fifth conductive portion.

FIG. 5A illustrates a portion of an exemplary electronic device.

FIG. 5B is a cross-sectional view of the electronic device of FIG. 5A taken along line A-A'.

FIG. 5C is a cross-sectional view of the electronic device of FIG. 5A taken along line B-B'.

FIG. 6 illustrates an exemplary connecting structure.

FIG. 7A schematically illustrates an unfolded state of an exemplary electronic device.

FIG. 7B schematically illustrates an intermediate state of an exemplary electronic device.

FIG. 7C illustrates an exemplary connecting structure illustrated in a portion X of FIG. 7A.

FIG. 8A illustrates a portion of an exemplary electronic device used as a signal path.

FIG. 8B is a flowchart illustrating an operation of at least one processor when an external object approaches.

FIG. 8C schematically illustrates impedance matching circuitry.

FIG. 8D is a flowchart illustrating an operation of at least one processor when an external object approaches.

FIG. 8E illustrates a radiation characteristic of an antenna in a relatively low frequency band.

FIG. 8F illustrates a radiation characteristic of an antenna in a relatively high frequency band.

FIG. 9 schematically shows an exemplary electronic device.

## [Mode for Invention]

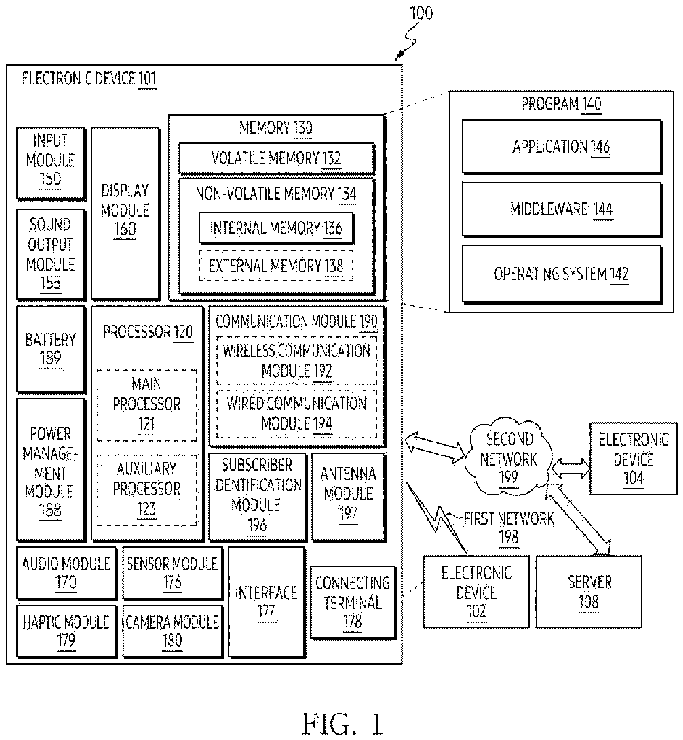

FIG. 1 is a block diagram illustrating an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

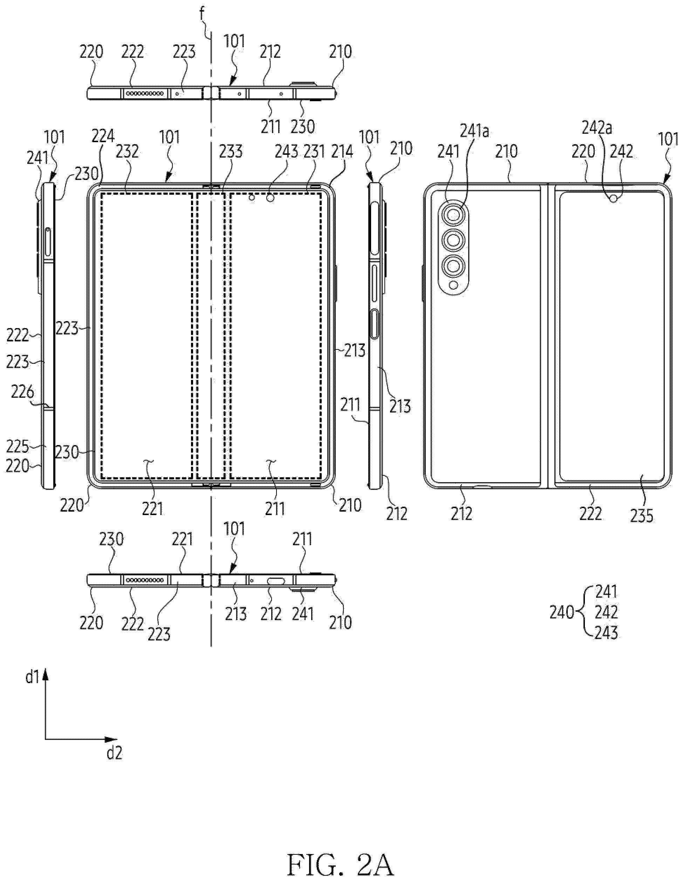

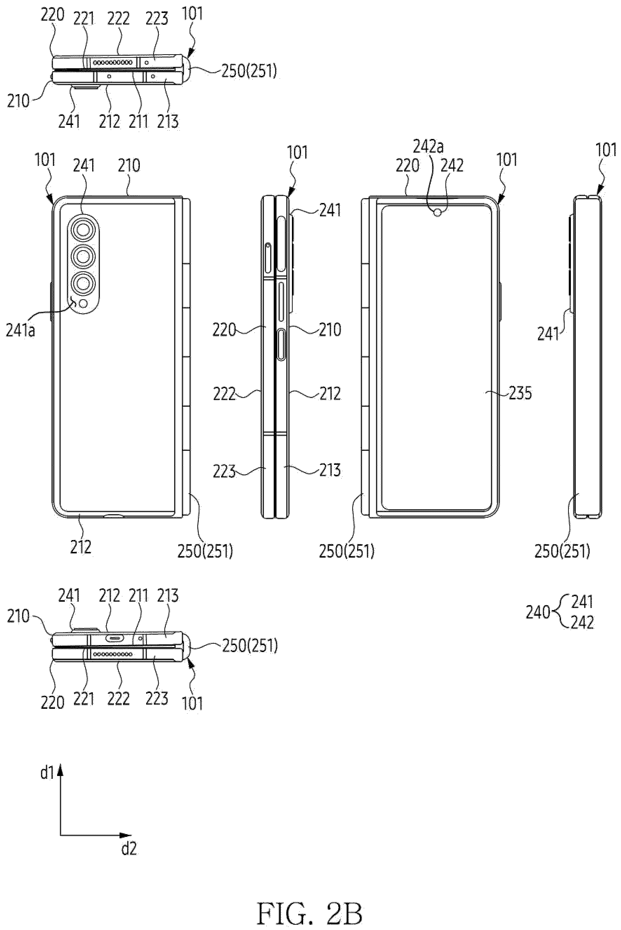

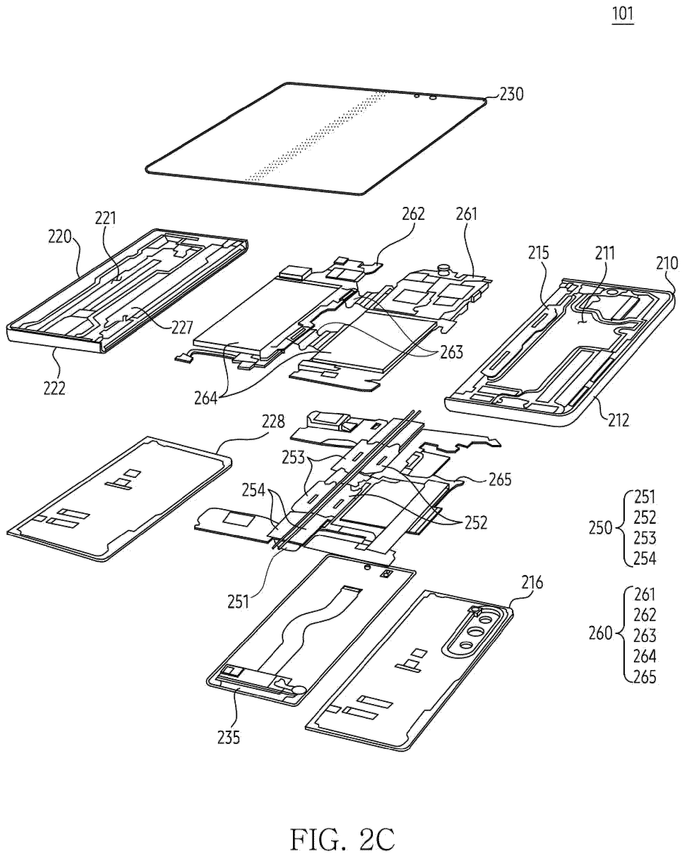

FIG. 2A illustrates an example of an unfolded state of an exemplary electronic device, FIG. 2B illustrates an example of a folded state of an exemplary electronic device, and FIG. 2C is an exploded view of an exemplary electronic device.

Referring to FIGS. 2A, 2B, and 2C, an electronic device 101 (e.g., the electronic device 101 of FIG. 1) may include a first housing 210, a second housing 220, and a display 230 (e.g., the display module 160 of FIG. 1), at least one camera 240, a hinge structure 250, and/or at least one electronic component 260.

According to an embodiment, the first housing 210 and the second housing 220 may form at least a portion of an outer surface of the electronic device 101. According to an embodiment, the first housing 210 may include a first surface 211, a second surface 212 opposite the first surface 211, and a first side surface 213 surrounding at least a portion of the first surface 211 and the second surface 212. The first side surface 213 may connect a periphery of the first surface 211 and a periphery of the second surface 212. The first surface 211, the second surface 212, and the first side surface 213 may form an inner space of the first housing 210. According to an embodiment, components disposed inside the first housing 210 may be disposed within a space formed by the first surface 211, the second surface 212, and the first side surface 213.

According to an embodiment, the second housing 220 may include a third surface 221, a fourth surface 222 opposite the third surface 221, and a second side surface 223 surrounding at least a portion of the third surface 221 and the fourth surface 222. The second side surface 223 may connect a periphery of the third surface 221 and a periphery of the fourth surface 222. The third surface 221, the fourth surface 222, and the second side surface 223 may form an inner space of the second housing 220. According to an embodiment, components disposed inside the second housing 220 may be disposed within a space formed by the third surface 221, the fourth surface 222, and the second side surface 223. According to an embodiment, the second housing 220 may be rotatably coupled to the first housing 210.

According to an embodiment, the first housing 210 may include a first lateral member 214 forming a first side surface 213. The second housing 220 may include a second lateral member 224 forming a second side surface 223. According to an embodiment, the first lateral member 214 and the second lateral member 224 may include at least one conductive portion 225 and at least one non-conductive portion 226. The at least one non-conductive portion 226 may be disposed between a plurality of conductive portions. The plurality of conductive portions may be separated from each other by the at least one non-conductive portion 226 disposed between the plurality of conductive portions. According to an embodiment, the at least one conductive portion 225 may operate as an antenna radiator used for communication with an external electronic device. For example, the electronic device 101 may communicate with an external electronic device via an antenna radiator including at least a portion of the plurality of conductive portions.

According to an embodiment, the display 230 may be configured to display visual information. According to an embodiment, the display 230 may be disposed on the first surface 211 of the first housing 210 and the third surface 221 of the second housing 220 across the hinge structure 250. For example, the display 230 may include a first display area 231 disposed on the first surface 211 of the first housing, a second display area 232 disposed on the third surface 221 of the second housing, and a third display area 233 disposed between the first display area 231 and the second display area 232. For example, the first display area 231, the second display area 232, and the third display area 233 may form a front surface of the display 230. According to an embodiment, the electronic device 101 may further include a sub-display panel 235 disposed on the fourth surface 222 of the second housing 220. For example, the display 230 may include a flexible display. According to an embodiment, the display 230 may include a window exposed toward the outside of the electronic device 101. The window may protect a surface of the display 230 and transmit, by including a substantially transparent material, visual information provided by the display 230 to the outside of the electronic device 101. For example, the window may include glass (e.g., ultra-thin glass (UTG)) and/or polymer (e.g., polyimide (PI)), but is not limited thereto.

The at least one camera 240 may be configured to obtain an image based on receiving light from a subject outside the electronic device 101. According to an embodiment, the at least one camera 240 may include first cameras 241, a second camera 242, or a third camera 243. In an embodiment, the first cameras 241 may be disposed in the first housing 210. For example, the first cameras 241 are disposed inside the first housing 210, and at least a portion of the first cameras 241 may be visible through the second surface 212 of the first housing 210. The first cameras 241 may be supported by a bracket (not illustrated) in the first housing 210. For example, when the electronic device 101 is viewed from above, the first housing 210 may include at least one opening 241a overlapping the first cameras 241. The first cameras 241 may obtain an image based on receiving light from the outside of the electronic device 101 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include at least one opening 242a overlapping the second camera 242 when the electronic device 101 is viewed from above. The second camera 242 may obtain an image based on receiving light from the outside of the electronic device 101 through the at least one opening 242a.

According to an embodiment, the third camera 243 may be disposed in the first housing 210. For example, the third camera 243 is disposed inside the first housing 210, and at least a portion of the third camera 243 may be visible through the first surface 211 of the first housing 210. For another example, the third camera 243 may be disposed inside the first housing 210, and at least a portion of the third camera 243 may be visible through the first display area 231 of the display 230. The first display area 231 of the display 230 may include at least one opening overlapping the third camera 243 when the display 230 is viewed from above. The third camera 243 may obtain an image based on receiving light from the outside of the display 230 through the at least one opening.

According to an embodiment, the second camera 242 and the third camera 243 may be disposed below the display 230 (e.g., in a direction toward the inside of the first housing 210 or the inside of the second housing 220). For example, the second camera 242 and/or the third camera 243 may be an under display camera (UDC). For example, when the second camera 242 and/or the third camera 243 is an under-display camera, an area of the display 230 corresponding to a location of each of the second camera 242 and the third camera 243 may not be an inactive area. The inactive area of the display 230 may mean an area of the display 230 that does not include pixels or does not emit light to the outside of the electronic device 101. For another example, the second camera 242 and the third camera 243 may be punch hole cameras. When the second camera 242 and the third camera 243 are punch hole cameras, an area of the display 230 corresponding to a location of each of the second camera 242 and the third camera 243 may be an inactive area.

According to an embodiment, the hinge structure 250 may rotatably connect the first housing 210 and the second housing 220. The hinge structure 250 may be disposed between the first housing 210 and the second housing 220 of the electronic device 101 so that the electronic device 101 may be bent, curved, or folded. For example, the hinge structure 250 may be disposed between a portion of the first side surface 213 and a portion of the second side surface 223, which face each other. The hinge structure 250 may change the electronic device 101 into an unfolded state in which a direction of the first surface 211 of the first housing 210 and a direction of the third surface 221 of the second housing 220 are the same, or a folded state in which the first surface 211 and the third surface 221 face each other. When the electronic device 101 is the folded state, the first housing 210 and the second housing 220 may face each other, thereby being stacked or overlapped.

According to an embodiment, when the electronic device 101 is the folded state, the direction of the first surface 211 and the direction of the third surface 221 may be different from each other. For example, when the electronic device 101 is the folded state, the direction of the first surface 211 and the direction of the third surface 221 may be opposite to each other. For another example, when the electronic device 101 is in the folded state, the direction of the first surface 211 and the direction of the third surface 221 may be inclined with respect to each other. When the direction of the first surface 211 is inclined with respect to the direction of the third surface 221, the first housing 210 may be inclined with respect to the second housing 220.

According to an embodiment, the electronic device 101 may be foldable with respect to a folding axis f. The folding axis f may mean an imaginary line extending past the hinge cover 251 in a direction (e.g., d1 in FIGS. 2A and 2B) parallel to a longitudinal direction of the electronic device 101, but is not limited thereto. For example, the folding axis f may be an imaginary line extending in a direction (e.g., d2 in FIGS. 2A and 2B) perpendicular to the longitudinal direction of the electronic device 101. When the folding axis f extends in the direction perpendicular to the longitudinal direction of the electronic device 101, the hinge structure 250 may extend in the direction parallel to the folding axis f and connect the first housing 210 and the second housing 220. The first housing 210 and the second housing 220 may be rotatable by the hinge structure 250 extending in the direction perpendicular to the longitudinal direction of the electronic device 101.

According to an embodiment, the hinge structure 250 may include a hinge cover 251, a first hinge plate 252, a second hinge plate 253, and a hinge module 254. The hinge cover 251 may surround internal components of the hinge structure 250. The hinge cover 251 may form an outer surface of the hinge structure 250. According to an embodiment, when the electronic device 101 is in the folded state, the hinge cover 251 surrounding the hinge structure 250 may be at least partially exposed to the outside of the electronic device 101 through a space between the first housing 210 and the second housing 220. According to another embodiment, when the electronic device 101 is in the unfolded state, the hinge cover 251 may be covered by the first housing 210 and the second housing 220 and may not be exposed to the outside of the electronic device 101.

According to an embodiment, the first hinge plate 252 and the second hinge plate 253 may rotatably connect the first housing 210 and the second housing 220, by being coupled to the first housing 210 and the second housing 220, respectively. For example, the first hinge plate 252 may be coupled to a first support member 215 of the first housing 210. The second hinge plate 253 may be coupled to a second support member 227 of the second housing 220. As the first hinge plate 252 and the second hinge plate 253 are coupled to the first support member 215 and the second support member 227, respectively, the first housing 210 and the second housing 220 may rotate according to a rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 with respect to the folding axis f, by including gears capable of being engaged with each other and rotating. According to an embodiment, the hinge modules 254 may be multiple.

According to an embodiment, the first housing 210 may include a first support member 215 and a first cover 216. For example, the second housing 220 may include a second support member 227 and a second cover 228. The first support member 215 may be disposed inside the first housing 210. The first support member 215 may support components of the electronic device 101. The first cover 216 may cover the second surface 212 of the first housing 210. The second support member 227 may be disposed inside the second housing 220. The second support member 227 may support components of the electronic device 101. The second cover 228 may cover the fourth surface 222 of the second housing 220. For example, the sub-display panel 235 may be disposed between the second support member 227 and the second cover 228. However, the disclosure is not limited thereto. For example, the second cover 228 may be omitted.

According to an embodiment, a portion of the first support member 215 may be surrounded by the first side surface 213. For example, a portion of the second support member 227 may be surrounded by the second side surface 223. For example, the first support member 215 may be integrally formed with the first side surface 213. For example, the second support member 227 may be integrally formed with the second side surface 223. However, the disclosure is not limited thereto. For example, the first support member 215 may be formed separately from the first side surface 213. For example, the second support member 227 may be formed separately from the second side surface 223.

The at least one electronic component 260 may implement various functions to be provided to a user. According to an embodiment, the at least one electronic component 260 may include a first PCB 261, a second PCB 262, a flexible PCB 263, a battery 264, and/or an antenna 265. The first PCB 261 and the second PCB 262 may form an electrical connection between components in the electronic device 101, respectively. For example, components (e.g., the processor 120 of FIG. 1) for implementing the overall function of the electronic device 101 may be disposed in the first PCB 261. Electronic components for implementing some functions of the electronic device 101 may be disposed in the second PCB 262. As another example, components for an operation of the sub-display panel 235 disposed on the fourth surface 222 may be disposed in the second PCB 262.

According to an embodiment, the first PCB 261 may be disposed in the first housing 210. For example, the first PCB 261 may be disposed on a surface of the first support member 215. According to an embodiment, the second PCB 262 may be disposed in the second housing 220. For example, the second PCB 262 may be disposed on a surface of the second support member 227. The flexible PCB 263 may connect the first PCB 261 and the second PCB 262. For example, the flexible PCB 263 may extend from the first PCB 261 to the second PCB 262.

The battery 264, which is a device for supplying power to at least one component of the electronic device 101, may include, for example, a non-rechargeable primary battery, a rechargeable secondary battery, or a fuel cell.

The antenna 265 may be configured to receive power or a signal from the outside of the electronic device 101. The antenna 265 may include, for example, a near field communication (NFC) antenna, an antenna module, and/or a magnetic secure transmission (MST) antenna. The antenna 265 may, for example, perform short-range communication with an external device or wirelessly transmit and/or receive power required for charging.

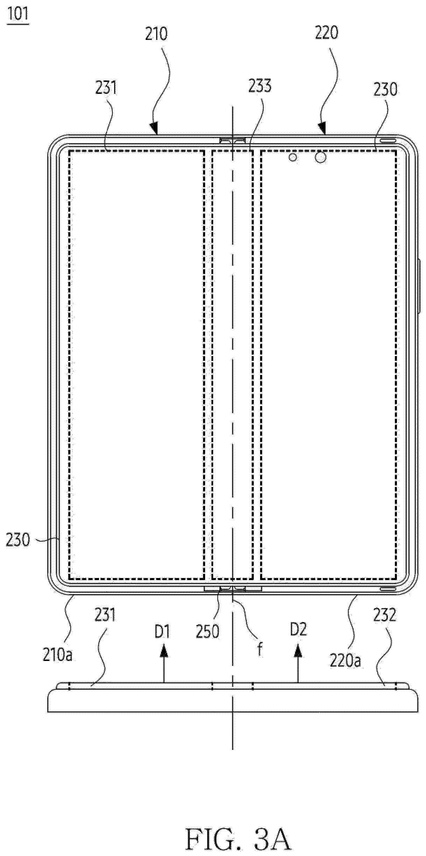

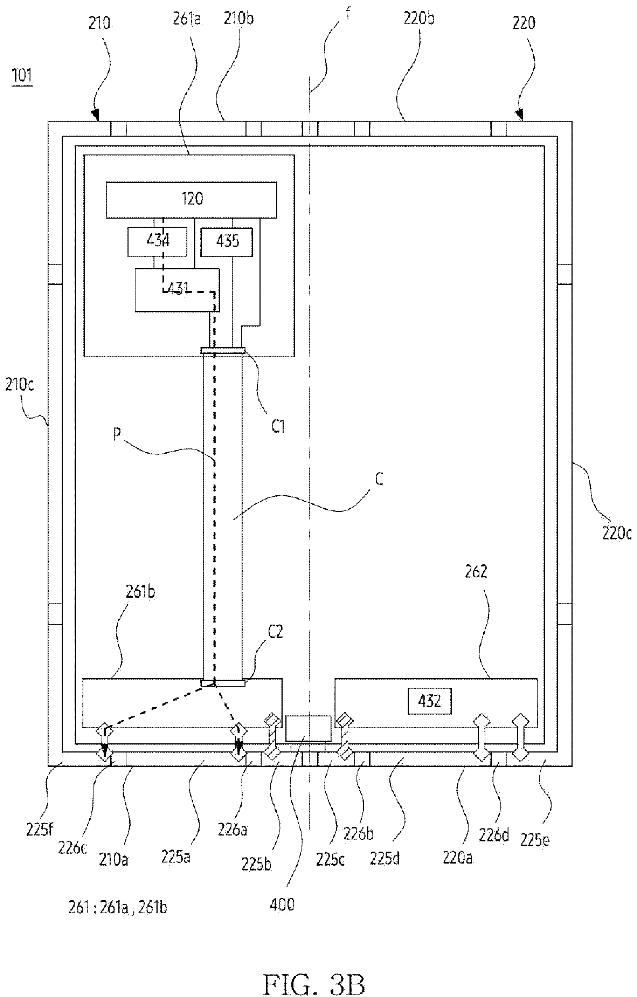

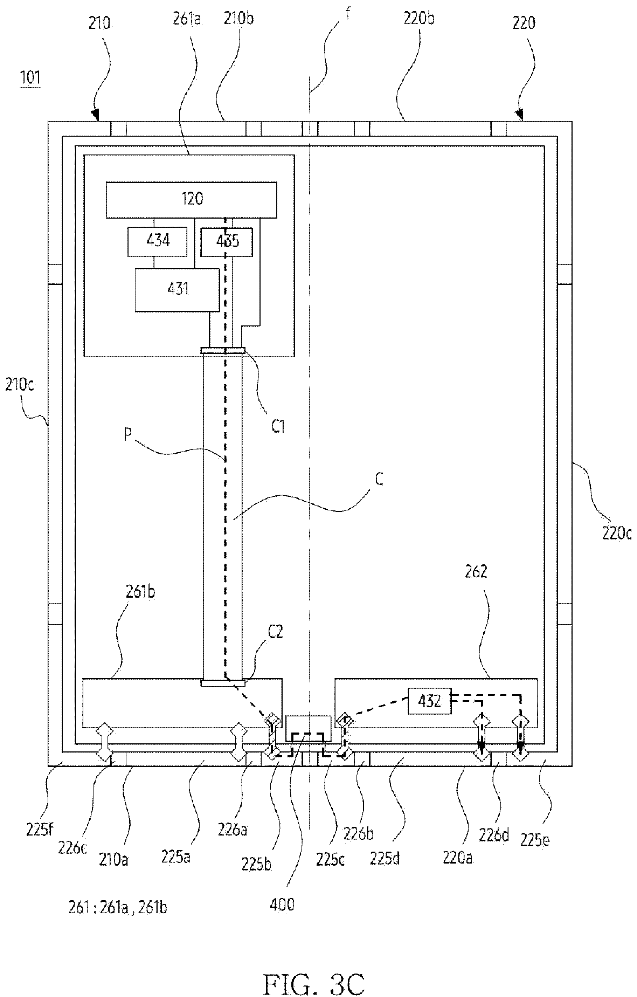

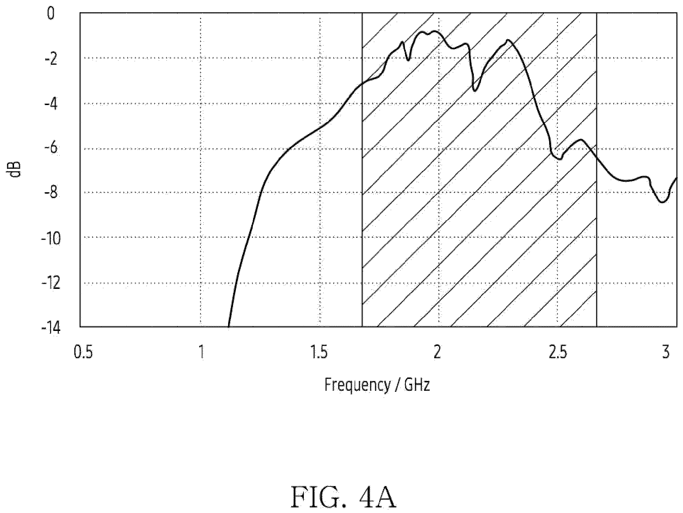

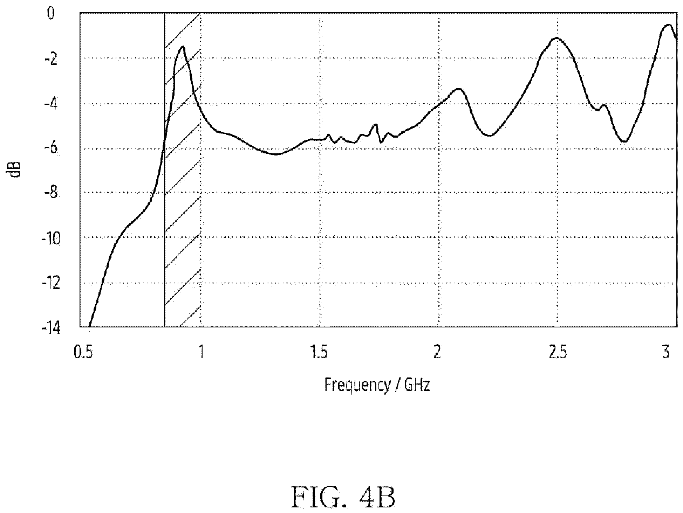

FIG. 3A schematically illustrates an exemplary electronic device. FIG. 3B illustrates a path for a signal when the electronic device of FIG. 3A communicates via a conductive portion of a first housing. FIG. 3C illustrates a path for a signal when the electronic device of FIG. 3A communicates via a conductive portion of a second housing. FIG. 4A is a graph illustrating a radiation characteristic of an antenna including a fourth conductive portion. FIG. 4B is a graph illustrating a radiation characteristic of an antenna including a fifth conductive portion.

Referring to FIGS. 3A and 3B, an electronic device 101 according to an embodiment may include a first housing 210, a second housing 220, a display 230, a connecting structure 400, and/or at least one processor 120.

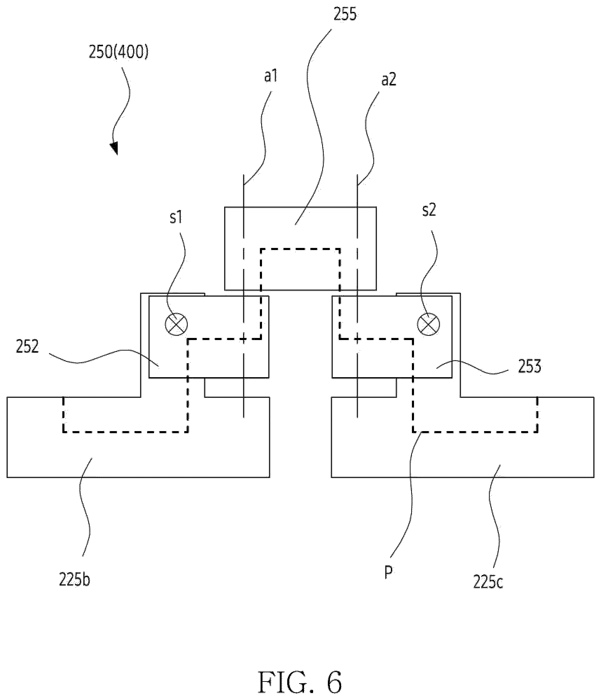

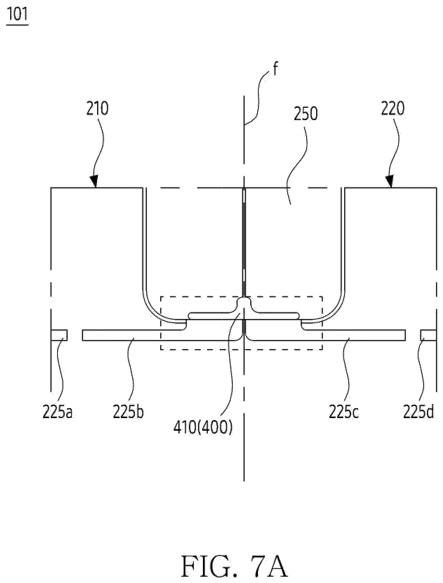

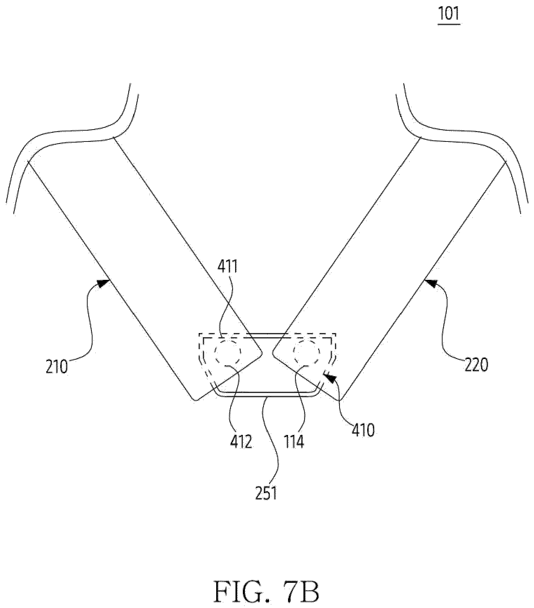

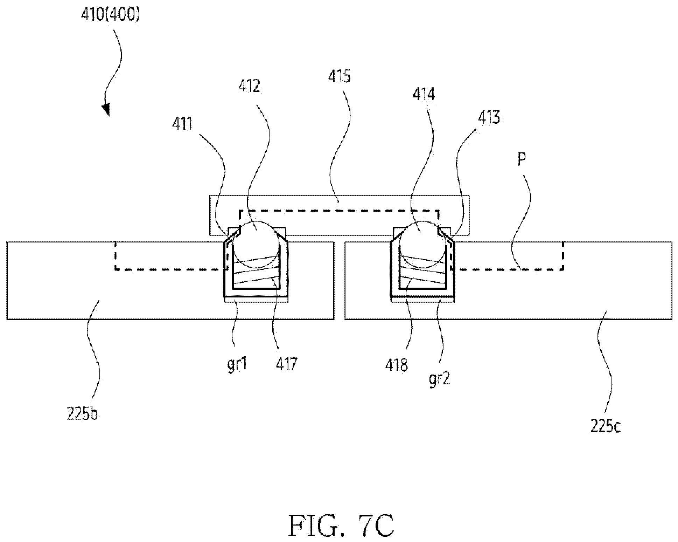

For example, the connecting structure 400 may be implemented in various ways. In an embodiment, the connecting structure 400 may be included in a hinge structure (e.g., the hinge structure 250 of FIG. 6). For example, an example of a hinge structure 250 used as a portion of a path for a wireless communication signal will be illustrated through FIG. 6. In an embodiment, the connecting structure 400 may be implemented as a cap (e.g., the cap 410 of FIG. 7C). For example, an example of a cap 410 used as a portion of a path for a wireless communication signal will be illustrated through FIGS. 7A, 7B, and 7C.

The electronic device 101 according to an embodiment may include a first housing 210 and a second housing 220 that may be folded or unfolded with each other. The electronic device 101 according to an embodiment may be referred to as a foldable electronic device. For example, the second housing 220 may be rotatable relative to the first housing 210 with respect to a folding axis f. For example, the electronic device 101 may include a hinge structure 250 (e.g., the hinge structure 250 of FIG. 2A). The hinge structure 250 may enable the electronic device 101 to be switched between a folded state or an unfolded state by rotatably connecting the first housing 210 and the second housing 220 with respect to the folding axis f.

According to an embodiment, the first housing 210 may include at least one first PCB 261. The at least one first PCB 261 may include a plurality of conductive layers and a plurality of non-conductive layers alternately laminated with the plurality of conductive layers. The at least one first PCB 261 may provide an electrical connection between various electronic components disposed on the at least one first PCB 261 and/or outside the at least one first PCB 261, by using wires and conductive vias formed in the conductive layer.

According to an embodiment, the display 230 may have flexibility. For example, the display 230 may be folded or unfolded by movement of the first housing 210 and/or movement of the second housing 220. The display 230 may include a first display area 231 disposed on the first housing 210, a second display area 232 disposed on the second housing 220, and a third display area 233 between the first display area 231 and the second display area 232. For example, in the folded state, a first direction D1 of the first display area 231 may be opposite to a second direction D2 of the second display area 232. In the unfolded state, the first direction D1 of the first display area 231 may correspond to the second direction D2 of the second display area 232.

According to an embodiment, the connecting structure 400 may be disposed across the folding axis f. "Disposed across the folding axis f" may indicate that it is positioned on the folding axis f. For example, the connecting structure 400 may extend from a side of the folding axis f to another side of the folding axis f across the folding axis f. For example, when a first periphery 210a is viewed in a direction parallel to the folding axis f, the connecting structure 400 may overlap at least a portion of a second conductive portion 225b. For example, when a second periphery 220a is viewed in the direction parallel to the folding axis f, the connecting structure 400 may overlap at least a portion of a third conductive portion 225c.

According to an embodiment, the connecting structure 400 may be used as a portion of a path for a wireless communication signal. Various embodiments of the connecting structure 400 will be described with reference to FIGS. 6 and/or 7C.

According to an embodiment, the at least one processor 120 may be configured to wirelessly communicate with an external electronic device. For example, the at least one processor 120 may be referred to as the processor 120 of FIG. 1 and/or a communication processor 312. The at least one processor 120 may be configured to receive a wireless communication signal from an external electronic device via an antenna. The at least one processor 120 may be configured to transmit a wireless communication signal to an external electronic device via an antenna. In an embodiment, the at least one processor 120 may be disposed on the at least one first PCB 261 in the first housing 210.

According to an embodiment, the first housing 210 and the second housing 220 may include a plurality of conductive portions. For example, the first housing 210 may include a first periphery 210a perpendicular to the folding axis f, a third periphery 210b opposite the first periphery 210a, and a fourth periphery 210c parallel to the folding axis f and between the first periphery 210a and the third periphery 210b. In an embodiment, the first housing 210 may include a first conductive portion 225a and a second conductive portion 225b disposed at the first periphery 210a perpendicular to the folding axis f from among peripheries of the first housing 210. However, the disclosure is not limited thereto. For example, the first housing 210 may further include, within the first periphery 210a, a sixth conductive portion 225f extending from a non-conductive portion 226c contacted with the first conductive portion 225a to a portion of the fourth periphery 210c.

For example, in the folded state, the second housing 220 may include a second periphery 220a facing the first periphery 210a, a fifth periphery 220b opposite the second periphery 220a, and a sixth periphery 220c parallel to the folding axis f and between the second periphery 220a and the fifth periphery 220b. In an embodiment, the second housing 220 may include a third conductive portion 225c and a fourth conductive portion 225d that are disposed at the second periphery 220a. However, the disclosure is not limited thereto. For example, the second housing 220 may further include, within the second periphery 220a, a fifth conductive portion 225e extending from a non-conductive portion 226d contacted with the fourth conductive portion 225d to a portion of the sixth periphery 220c. For example, in the unfolded state, the first periphery 210a and the second periphery 220a may be placed on substantially the same line.

According to an embodiment, the first conductive portion 225a and the second conductive portion 225b may be electrically disconnected from each other. The third conductive portion 225c and the fourth conductive portion 225d may be electrically disconnected. For example, a first non-conductive portion 226a may be disposed between the first conductive portion 225a and the second conductive portion 225b. For example, a second non-conductive portion 226b may be disposed between the third conductive portion 225c and the fourth conductive portion 225d.

According to an embodiment, at least one of a plurality of conductive portions of the first housing 210 may operate as a portion of an antenna. Referring to FIG. 3B, at least one first PCB 261 may be electrically connected to the first conductive portion 225a and/or the sixth conductive portion 225f. In an embodiment, the at least one processor 120 may be configured to feed power to the first conductive portion 225a and/or the sixth conductive portion 225f via the at least one first PCB 261. Through an electromagnetic field formed when an alternating current flows at the first conductive portion 225a and/or the sixth conductive portion 225f, the first conductive portion 225a and/or the sixth conductive portion 225f may operate as a portion of an antenna resonating on a designated resonant frequency.

For example, the at least one first PCB 261 may include a main PCB 261a or a sub-PCB 261b. For example, the main PCB 261a may be positioned close to various electronic components of the first housing 210. According to an embodiment, the main PCB 261a may be positioned closer to the third periphery 210b from among the first periphery 210a and the third periphery 210b opposite the first periphery 210a. The sub-PCB 261b may be positioned closer to the first periphery 210a from among the first periphery 210a and the third periphery 210b. The main PCB 261a and the sub-PCB 261b may be electrically connected to each other via a cable C. For example, the cable C may include a first connector C1 connected to the main PCB 261a and a second connector C2 connected to the sub-PCB 261b. The cable C may extend from the first connector C1 to the second connector C2. For example, the cable C may be a coaxial cable or a flexible PCB, but is not limited thereto.

For example, at least one processor 120, a first power amplifier module (PAM) 434, a second PAM 435, and/or a first filter 431 may be disposed on the main PCB 261a. The at least one processor 120 may be configured to receive and/or transmit a wireless communication signal. The at least one processor 120 may be electrically connected to the first PAM 434 and/or the second PAM 435 for setting transmission power and/or reception power of a first signal transmitted to an external electronic device or reception power of a second signal received from an external electronic device. The first filter 431 may be configured to filter a signal having a designated frequency range. For example, the first filter 431 may pass a signal having a designated frequency range. The first filter 431 may be configured to block a signal having a frequency range other than a signal in a designated frequency range.

FIG. 3B illustrates a path P of a first signal and/or a second signal when the at least one processor 120 transmits the first signal via the first conductive portion 225a and/or the sixth conductive portion 225f, or receives a second signal from an external electronic device via the first conductive portion 225a and/or the sixth conductive portion 225f. For example, the first signal may be provided from the main PCB 261a to the sub-PCB 261b via the cable C. The first signal may be transmitted to the outside of the electronic device 101 via the first conductive portion 225a and/or the sixth conductive portion 225f electrically connected to the sub-PCB 261b. When the at least one processor 120 receives the second signal via the first conductive portion 225a and/or the sixth conductive portion 225f, the second signal may be provided to the sub-PCB 261b via the first conductive portion 225a and/or the sixth conductive portion 225f. The second signal may be received from the sub-PCB 261b to at least one processor 120 on the main PCB 261a via the cable C. The path of the first signal may be substantially the same as a path through which the at least one processor 120 receives the second signal from an external electronic device.

FIG. 3C illustrates a path P of a first signal and/or a second signal when the at least one processor 120 transmits a first signal via the fourth conductive portion 225d and/or the fifth conductive portion 225e or receives a second signal from an external electronic device via the fourth conductive portion 225d and/or the fifth conductive portion 225d. In an embodiment, at least one of the plurality of conductive portions of the second housing 220 may operate as an antenna radiator. For example, the fourth conductive portion 225d and/or the fifth conductive portion 225e may be configured to transmit the first signal or receive the second signal. Since the fourth conductive portion 225d and the fifth conductive portion 225e are disposed in the second housing 220, a transmission path P of the first signal and/or the second signal may be required for the at least one processor 120 to communicate with an external electronic device via the fourth conductive portion 225d and/or the fifth conductive portion 225e.

According to an embodiment, the connecting structure 400 may electrically connect the second conductive portion 225b and the third conductive portion 225c. The connecting structure 400 may be used as a portion of the path P for the first signal and/or the second signal, between the first housing 210 and the second housing 220. According to an embodiment, the connecting structure 400 may be used as a path for the first signal provided from the at least one processor 120 to the fourth conductive portion 225d and/or the fifth conductive portion 225e. The connecting structure 400 may be used as a path for the second signal provided to the at least one processor 120 from the fourth conductive portion 225d. The connecting structure 400 may be connected to the first conductive portion 225a and the second conductive portion 225b, respectively. For example, the connecting structure 400 may not be electrically connected to conductive components included in the electronic device 101 other than the first conductive portion 225a and the second conductive portion 225b.

For example, when the at least one processor 120 transmits the first signal via the fourth conductive portion 225d and/or the fifth conductive portion 225e, the first signal may be provided from the at least one processor 120 to the at least one first PCB 261 and the second conductive portion 225b via the cable C. The first signal may be provided to the third conductive portion 225c via the connecting structure 400 connected to the second conductive portion 225b. Since the connecting structure 400 is disposed across the folding axis f, the connecting structure 400 may provide the first signal from the first housing 210 to the second housing 220. The first signal provided to the third conductive portion 225c may be provided to the fourth conductive portion 225d and/or the fifth conductive portion 225e. For example, the second housing 220 may include a second PCB 262 and a second filter 432 disposed on the second PCB 262. The second filter 432 may be electrically connected to the fourth conductive portion 225d and the fifth conductive portion 225e. The second filter 432 may be configured to transfer the first signal to the fourth conductive portion 225d and/or the fifth conductive portion 225e, based on the resource frequency of the first signal. The first signal provided to the fourth conductive portion 225d and/or the fifth conductive portion 225e may be transmitted to the outside of the electronic device 101 via the fourth conductive portion 225d and/or the fifth conductive portion 225e.

According to an embodiment, a length of the fourth conductive portion 225d may be different from a length of the fifth conductive portion 225e. For example, the length of the fourth conductive portion 225d may be shorter than the length of the fifth conductive portion 225e, but is not limited thereto. A resonant frequency of an antenna including the fourth conductive portion 225d or the fifth conductive portion 225e may be determined based on a length of the fourth conductive portion 225d or a length of the fifth conductive portion 225e. For example, in case that the length of the fourth conductive portion 225d is shorter than the length of the fifth conductive portion 225e, a resonant frequency of the fourth conductive portion 225d may be greater than a resonant frequency of the fifth conductive portion 225e. The second filter 432 in the second housing 220 may be configured to provide the first signal to the fourth conductive portion 225d and/or the fifth conductive portion 225e, based on a resonant frequency of the first signal.

Referring to FIGS. 4A and 4B, a radiation characteristic of a fourth conductive portion (e.g., the fourth conductive portion 225d of FIG. 3B) and a radiation characteristic of a fifth conductive portion (e.g., the fifth conductive portion 225e of FIG. 3B) may be different.

FIG. 4A illustrates a radiation characteristic of an antenna including the fourth conductive portion 225d, and FIG. 4B illustrates a radiation characteristic of an antenna including the fifth conductive portion 225e. Referring to FIG. 4A, the antenna including the fourth conductive portion 225d may have a resonant frequency of about 1.7 GHz to about 2.6 GHz. When a frequency of the first signal is about 2 GHz (e.g., about 1.7 GHz to about 2.6 GHz), a second filter (e.g., the second filter 432 of FIG. 3C) may be configured to provide the first signal to the fourth conductive portion 225d. Referring to FIG. 4B, the antenna including the fifth conductive portion 225e may have a resonant frequency of about 900 MHz. When a frequency of the first signal is about 900 MHz (e.g., about 800 MHz to about 1,000 MHz), the second filter 432 may be configured to provide the first signal to the fifth conductive portion 225e.

Referring back to FIG. 3C, when the at least one processor 120 receives the second signal via the fourth conductive portion 225d and/or the fifth conductive portion 225e, the second signal may be provided from the fourth conductive portion 225d and/or the fifth conductive portion 225e to the third conductive portion 225c. For example, the second signal received via the fourth conductive portion 225d and/or the fifth conductive portion 225e may be provided to the second filter 432 electrically connected to the fourth conductive portion 225d and/or the fifth conductive portion 225e. The second signal provided to the second filter 432 may be provided to the third conductive portion 225c via the second filter 432. The second signal provided to the third conductive portion 225c may be provided to the second conductive portion 225b via the connecting structure 400 connected to the third conductive portion 225c. Since the connecting structure 400 is disposed across the folding axis f, the connecting structure 400 may provide the second signal from the second housing 220 to the first housing 210. The second signal provided to the second conductive portion 225b may be provided to the at least one processor 120 via the at least one first PCB 261. For example, the second signal provided to the second conductive portion 225b may be provided to the main PCB 261a via the sub-PCB 261b or the cable C. The at least one processor 120 disposed on the main PCB 261a may receive the second signal via the main PCB 261a.

According to an embodiment, when the at least one processor 120 transmits the first signal via a conductive portion (e.g., the fourth conductive portion 225d, the fifth conductive portion 225e) of the second housing 220 or receives the second signal via the conductive portion of the second housing 220, the connecting structure 400 may be used as a path P for the first signal and/or a path P for the second signal. Even when the electronic device 101 according to an embodiment does not include an additional component (e.g., a coaxial cable or a flexible PCB) for a transmission path P of the first signal and/or the second signal across the first housing 210 and the second housing 220, the at least one processor 120 in the first housing 210 may be electrically connected to a conductive portion of the second housing 220 via a physical configuration (e.g., the second conductive portion 225b) of the first housing 210, a physical configuration (e.g., the third conductive portion 225c) of the second housing 220, and the connecting structure 400. When the conductive portion of the second housing 220 operates as an antenna, as the connecting structure 400 provides the transmission path P of the first signal and/or the second signal, the electronic device 101 according to an embodiment may communicate with an external electronic device via the conductive portion of the second housing 220.

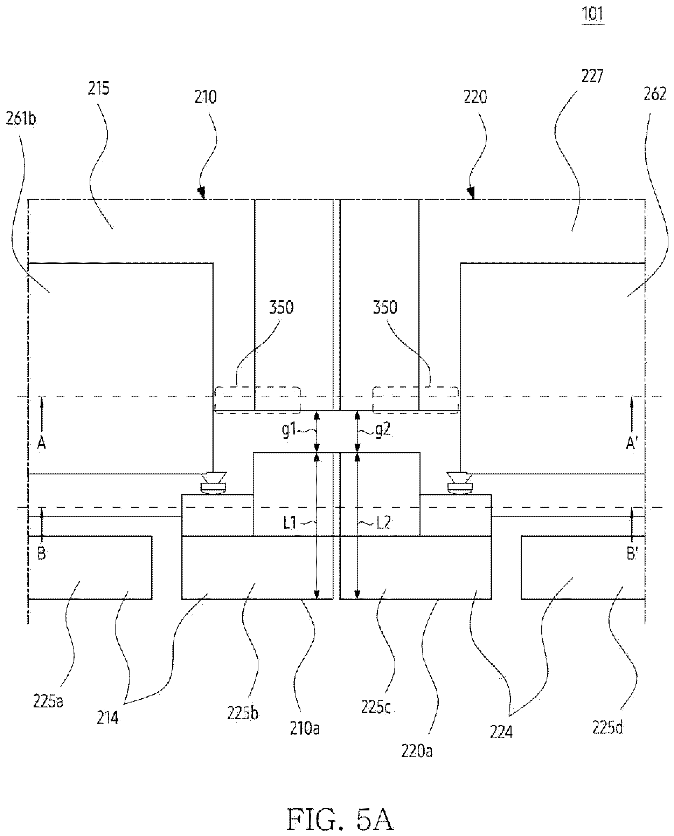

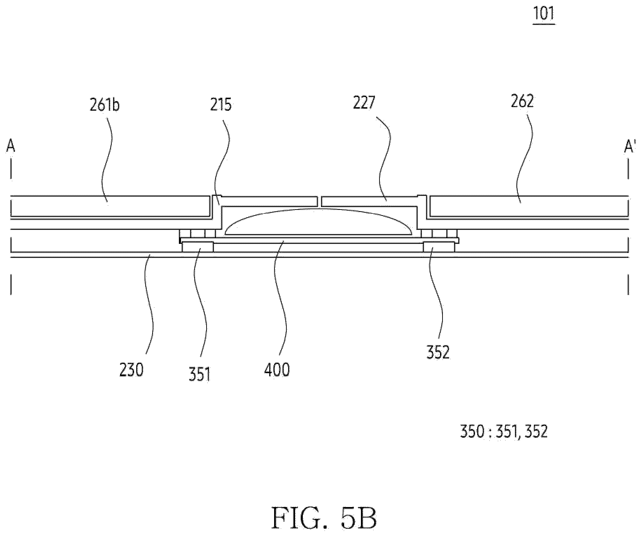

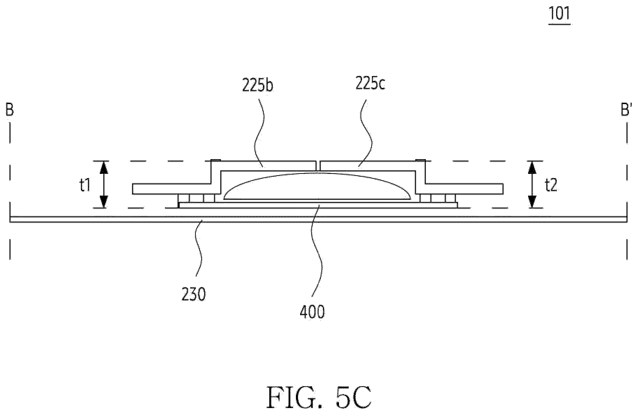

FIG. 5A illustrates a portion of an exemplary electronic device 101. FIG. 5B is a cross-sectional view of the electronic device 101 of FIG. 5A taken along line A-A'. FIG. 5C is a cross-sectional view of the electronic device 101 of FIG. 5A taken along line B-B'.

Referring to FIG. 5A, a first housing 210 may include a first support member 215. A second housing 220 may include a second support member 227. According to an embodiment, a first lateral member 214, which forms peripheries (e.g., the first periphery 210a) of the first housing 210, and the first support member 215 may include a portion spaced apart from each other. For example, a second conductive portion 225b of the first lateral member 214 may be spaced apart from the first support member 215. A second lateral member 224, which forms peripheries (e.g., the second periphery 220a) of the second housing 220, and the second support member 227 may include a portion spaced apart from each other. For example, a third conductive portion 225c of the second lateral member 224 may be spaced apart from the second support member 227. However, the disclosure is not limited thereto. A non-conductive material (e.g., resin) may be filled in a spaced portion between the first lateral member 214 and the first support member 215 and a spaced portion between the second lateral member 224 and the second support member 227.

According to an embodiment, the first support member 215 may support components within the first housing 210. For example, a sub-PCB 261b may be disposed on the first support member 215. The second support member 227 may support components within the second housing 220. For example, a second PCB 262 may be disposed on the second support member 227.

According to an embodiment, the second conductive portion 225b, the third conductive portion 225c, and a connecting structure 400 may be used as a path for a signal. In an embodiment, the second conductive portion 225b and the third conductive portion 225c may be configured to have a designated impedance value in order to be utilized as a path for a signal. For example, the second conductive portion 225b and the third conductive portion 225c may be configured to have about 50 ohms.

In a case of a two-wire transmission line including two linear conductors arranged parallel to each other, the impedance value may be calculated according to [Equation 1] below.

[Equation 1]

$$Z_0 = 120\sqrt{\varepsilon_r} \cdot \mathrm{acosh}(1 + \frac{g}{L})$$

($Z_0$: impedance value, $\varepsilon_r$: relative permittivity, g: gap between conductors, L: width of line)

In the electronic device 101 according to an embodiment, the relative permittivity $\varepsilon$) in [Equation 1] may refer to relative permittivity of a non-conductive material (e.g., resin) filled between the first support member 215 and the first lateral member 214 and between the second support member 227 and the second lateral member 224. In the electronic device 101 according to an embodiment, the gap g between conductors in [Equation 1] may refer to a first gap g1 between the first support member 215 and the second conductive portion 225b and/or a second gap g2 between the second support member 227 and the third conductive portion 225c. In the electronic device 101 according to an embodiment, the width L of the line in [Equation 1] may refer to a first width L1 of the second conductive portion 225b and/or a second width L2 of the third conductive portion 225c. The first gap g1 may be substantially the same as the second gap g2. The first width L1 may be substantially the same as the second width L2. However, the disclosure is not limited thereto.

According to an embodiment, the second conductive portion 225b and the third conductive portion 225c may be designed based on [Equation 1] to have a designated impedance value (e.g., about 50 ohms). Since the relative permittivity $\varepsilon_r$ of the non-conductive material has a value determined according to the non-conductive material, in order to have a designated impedance value (e.g., 50 ohms), the first width L1 may be determined based on the first gap g1, and the second width L2 may be determined based on the second gap g2. For example, the first width L1 of the second conductive portion 225b may be proportional to the first gap g1 between the first support member 215 and the second conductive portion 225b. For example, the second width L2 of the third conductive portion 225c may be proportional to the second gap g2 between the second support member 227 and the third conductive portion 225c.

For example, when the relative permittivity $\varepsilon_r$ of the non-conductive material is about 3, and the first width L1 and the second width L2 are about 7.35 mm, the first gap g1 and the second gap g2 may be about 2 mm. For example, when the relative permittivity $\varepsilon_r$ of the non-conductive material is about 3, and the first width L1 and the second width L2 are about 5.9 mm, the first gap g1 and the second gap g2 may be about 1.6 mm. However, the disclosure is not limited thereto.

In a case of a parallel-plate transmission line including two conductive parallel plates arranged parallel to each other, the impedance value may be calculated according to [Equation 2] below.

[Equation 2]

$$Z_0 = \frac{120\pi}{\sqrt{\varepsilon_r}} \cdot \frac{g}{t}$$

(Zo: impedance value, $\varepsilon_r$: relative permittivity, g: gap between conductors, t: thickness of parallel plates)

In the electronic device 101 according to an embodiment, the relative permittivity $\varepsilon_r$ of [Equation 2] above may be referred to as relative permittivity of a non-conductive material (e.g., resin) filled between the first support member 215 and the first lateral member 214 and between the second support member 227 and the second lateral member 224. In the electronic device 101 according to an embodiment, the gap g between the conductors in [Equation 2] may refer to a first gap g1 between the first support member 215 and the second conductive portion 225b and/or a second gap g2 between the second support member 227 and the third conductive portion 225c. Referring to FIG. 5C, in the electronic device 101 according to an embodiment, a thickness t of the parallel plate in [Equation 2] may refer to a first thickness t1, which is a sum of a thickness of the second conductive portion 225b and a thickness of the connecting structure 400, and/or a second thickness t2, which is a sum of a thickness of the third conductive portion 225c and a thickness of the connecting structure 400. The first gap g1 may be substantially the same as the second gap g2. The first thickness t1 may be substantially the same as the second thickness t2. However, the disclosure is not limited thereto.

According to an embodiment, the second conductive portion 225b, the third conductive portion 225c, and the connecting structure 400 may be designed based on the [Equation 2] to have a designated impedance value (e.g., about 50 ohms). Since the relative permittivity $\varepsilon_r$ of the non-conductive material has a value determined according to the non-conductive material, in order to have the designated impedance value, the first gap g1 may be determined based on the first thickness t1. The second gap g2 may be determined based on the second thickness t2. For example, the first gap g1 may be proportional to the first thickness t1. For example, the second gap g2 may be proportional to the second thickness t2.

For example, when the relative permittivity $\varepsilon_r$ of the non-conductive material is about 3 and the first gap g1 and the second gap g2 are about 8.7 mm, the first thickness t1 and the second thickness t2 may be about 2 mm. For example, when the first gap g1 and the second gap g2 are about 7 mm, the first thickness t1 and the second thickness t2 may be about 1.6 mm. However, the disclosure is not limited thereto. According to an embodiment, the first gap g1 and the second gap g2 may be about 2mm, the first width L1 and the second width L2 may be about 7mm, and the first thickness t1 and the second thickness t2 may be about 7mm.

Referring to FIG. 5B, the display 230 may be electrically connected to the connecting structure 400. For example, a connection member 350 for shorting the connection structure 400 and the display 230 may be disposed between the connection structure 400 and the display 230. For example, the connection member 350 may be a C-clip, bearing, and/or conductive foam, but is not limited thereto. For example, the connection member 350 may include a first connection member 351 electrically connecting the display 230 and the first support member 215 and a second connection member 352 electrically connecting the display 230 and the second support member 227. However, the disclosure is not limited thereto. According to an embodiment, the connection member 350 may electrically connect the display 230 to the first support member 215 and the second support member 227. For example, the display 230 may be electrically connected to a ground of the first support member 215 and a ground of the second support member 227 by being electrically connected to the first support member 215 and the second support member 227.

Referring to FIG. 5C, the display 230 may be electrically disconnected from the second conductive portion 225b and the third conductive portion 225c. For example, the display 230 may be spaced apart from the second conductive portion 225b, the third conductive portion 225c, and the connecting structure 400. The connecting structure 400 illustrated in FIG. 5C may be physically separated from or electrically disconnected from the connecting structure illustrated in FIG. 5B. Since the display 230 includes a conductive material, the display 230 may affect an electrical signal transmitted along the second conductive portion 225b and the third conductive portion 225c. The first signal and/or the second signal may be distorted, by the display 230, at a certain frequency. According to an embodiment, in order to reduce the influence by the display 230, the display 230 may be shorted to the first support member 215 and the second support member 227 via the connection member 350 and may be electrically disconnected from the second conductive portion 225b, the third conductive portion 225c, and the connecting structure 400. The display 230 may be electrically connected to the first support member 215 and the second support member 227 via the connection member 350. Since the first support member 215 and the second support member 227 are electrically disconnected from the second conductive portion 225b and the third conductive portion 225c, an electromagnetic interaction between the display 230 and a signal transmitted and/or received via the second conductive portion 225b, the third conductive portion 225c, and the connecting structure 400 may be reduced.

FIG. 6 illustrates an exemplary connecting structure.

Referring to FIG. 6, a connecting structure 400 may be included in a hinge structure 250. In an embodiment, the connecting structure 400 may be implemented as at least a portion of the hinge structure 250. According to an embodiment, the hinge structure 250 may include a first hinge plate 252, a second hinge plate 253, and a third hinge plate 255. However, the disclosure is not limited thereto. The connecting structure 400 may be implemented as a portion of the hinge structure 250 or may be implemented separately from the hinge structure 250.

According to an embodiment, the first hinge plate 252 may be connected to a second conductive portion 225b. The second hinge plate 253 may be connected to a third conductive portion 225c. For example, the first hinge plate 252 and the second conductive portion 225b may be coupled to each other by a first screw S 1. The second hinge plate 253 and the third conductive portion 225c may be coupled to each other by a second screw S2. The third hinge plate 255 may electrically connect the first hinge plate 252 and the second hinge plate 253. For example, the first hinge plate 252 may be rotatably coupled to the third hinge plate 255 with respect to a first axis a1. The second hinge plate 253 may be rotatably coupled to the third hinge plate 255 with respect to a second axis a2 distinct from the first axis a1. In an unfolded state, the first hinge plate 252 and the second hinge plate 253 may be disposed on substantially the same plane. In a folded state, the first hinge plate 252 and the second hinge plate 253 may face each other.

According to an embodiment, the hinge structure 250 may rotatably connect a first housing (e.g., the first housing 210 of FIG. 3A) and a second housing (e.g., the second housing 220 of FIG. 3B) to each other. The hinge structure 250 may be disposed between the first housing 210 and the second housing 220 to rotatably connect the first housing 210 and the second housing 220 to each other. The hinge structure 250 disposed between the first housing 210 and the second housing 220 may be used as a path P for a first signal and/or a second signal.

According to an embodiment, the first signal may be provided from the second conductive portion 225b to the third conductive portion 225c via the hinge structure 250. For example, the first signal provided to the second conductive portion 225b may be provided to the first hinge plate 252 connected to the second conductive portion 225b. The first signal may be provided from the first hinge plate 252 to the second hinge plate 253 via the third hinge plate 255. The first signal provided to the second hinge plate 253 may be provided to the third conductive portion 225c connected to the second hinge plate 253. The hinge structure 250 may be used as a path for the first signal.

According to an embodiment, the second signal may be provided from the third conductive portion 225c to the second conductive portion 225b via the hinge structure 250. For example, the second signal provided to the third conductive portion 225c may be provided to the second hinge plate 253 connected to the third conductive portion 225c. The second signal may be provided from the second hinge plate 253 to the first hinge plate 252 via the third hinge plate 255. The first signal provided to the first hinge plate 252 may be provided to the second conductive portion 225b connected to the first hinge plate 252. The hinge structure 250 may be used as a path for the second signal.

Even when an electronic device (e.g., electronic device 101 of FIG. 3A) according to an embodiment does not include an additional component (e.g., coaxial cable, flexible PCB) for a transmission path of a signal across the first housing 210 and the second housing 220, at least one processor (e.g., the at least one processor 120 of FIG. 3A) may be electrically connected to a conductive portion of the second housing 220 via the hinge structure 250. When the conductive portion of the second housing 220 operates as an antenna, as the hinge structure 250 provides the transmission path P of the first signal and/or the second signal, the electronic device 101 according to an embodiment may communicate with an external electronic device via the conductive portion of the second housing 220.

FIG. 7A schematically illustrates an unfolded state of an exemplary electronic device. FIG. 7B schematically illustrates an intermediate state of an exemplary electronic device 101. FIG. 7C illustrates an exemplary connecting structure 400 illustrated in a portion X of FIG. 7A. FIG. 7B schematically illustrates an intermediate state of an exemplary electronic device 101.

Referring to FIGS. 7A and 7C, a connecting structure 400 may be implemented as a cap 410. In an embodiment, the connecting structure 400 may be implemented as at least a portion of the cap 410. According to an embodiment, the cap 410 may include a first cover 411, a second cover 413, and a conductive cover 415. However, the disclosure is not limited thereto. The connecting structure 400 may be implemented as at least a portion of the cap 410, or may be implemented separately from the cap 410.

Referring to FIG. 7A, the cap 410 may be connected between the first housing 210 and the second housing 220, and the hinge structure 250. The cap 410 may reduce foreign substances (e.g., dust) entering between the first housing 210 and the second housing 220. Referring to FIG. 7B, foreign substances (e.g., dust) entering between the first housing 210 and the second housing 220 may be reduced. For example, when the electronic device 101 is switched from the unfolded state to the folded state, the first housing 210 and the second housing 220 may be widened. The cap 410 may reduce the inflow of foreign substances between the first housing 210 and the second housing 220 by covering a space between the first housing 210 and the second housing 220. The cap 410 may be disposed between the first housing 210 and the second housing 220 to cover the space between the first housing 210 and the second housing 220. For example, the cap 410 may include a conductive cover 415 coupled to the hinge cover 251, a first ball bearing 412, and a second ball bearing 414. When the electronic device 101 is switched from the folded state to the unfolded state, or from the unfolded state to the folded state, the first housing 210 may be rotated with respect to the first ball bearing 412. The second housing 220 may be rotated with respect to the second ball bearing 414. According to an embodiment, the cap 410 disposed between the first housing 210 and the second housing 220 may be used as a path for a first signal and/or a path P for a second signal.

Referring to FIG. 7C, the first cover 411 may be accommodated in a first groove gr1 of the second conductive portion 225b. The first cover 411 may include a first ball bearing 412 disposed in the first cover 411 and a first elastic body 417 supporting the first ball bearing 412. The first cover 411 may be electrically connected to the second conductive portion 225b. The second cover 413 may be accommodated in a second groove gr2 of the third conductive portion 225c. The second cover 413 may include a second ball bearing 414 disposed in the second cover 413 and a second elastic body 418 supporting the second ball bearing 414. The second cover 413 may be electrically connected to the third conductive portion 225c. The conductive cover 415 may be coupled to the first cover 411 and the second cover 413. The conductive cover 415 may be configured to press the first ball bearing 412 and the second ball bearing 414 by covering the first cover 411 and the second cover 413. The conductive cover 415 may contact the first ball bearing 412 and the second ball bearing 414. The first ball bearing 412 and the second ball bearing 414 may include a conductive material (e.g., metal). A first housing (e.g., the first housing 210 of FIG. 3A) may be rotated relative to the cap 410 via the first ball bearing 412. A second housing (e.g., the second housing 220 of FIG. 3B) may be rotated relative to the cap 410 via the second ball bearing 414.

According to an embodiment, the first signal may be provided from the second conductive portion 225b to the third conductive portion 225c via the cap 410. For example, the first signal provided to the second conductive portion 225b may be provided to the conductive cover 415 via the first cover 411 connected to the second conductive portion 225b and/or the first ball bearing 412. The first signal provided to the conductive cover 415 may be provided to the third conductive portion 225c via the second cover 413 connected to the third conductive portion 225c and/or the second ball bearing 414. The cap 410 may be used as a path for the first signal.

According to an embodiment, the second signal may be provided from the third conductive portion 225c to the second conductive portion 225b via the cap 410. For example, the second signal provided to the third conductive portion 225c may be provided to the conductive cover 415 via the second cover 413 connected to the third conductive portion 225c and/or the second ball bearing 414. The second signal provided to the conductive cover 415 may be provided to the second conductive portion 225b via the first cover 411 connected to the second conductive portion 225b and/or the first ball bearing 412. The cap 410 may be used as a path for the second signal.

Even when the electronic device 101 according to an embodiment does not include an additional component (e.g., coaxial cable or flexible PCB) for a transmission path of a signal across the first housing 210 and the second housing 220, at least one processor (e.g., the at least one processor 120 of FIG. 3A) may be electrically connected to a conductive portion of the second housing 220 via the cap 410. When the conductive portion of the second housing 220 operates as an antenna, as the cap 410 provides a transmission path P of the first signal and/or the second signal, the electronic device 101 according to an embodiment may communicate with an external electronic device via the conductive portion of the second housing 220.

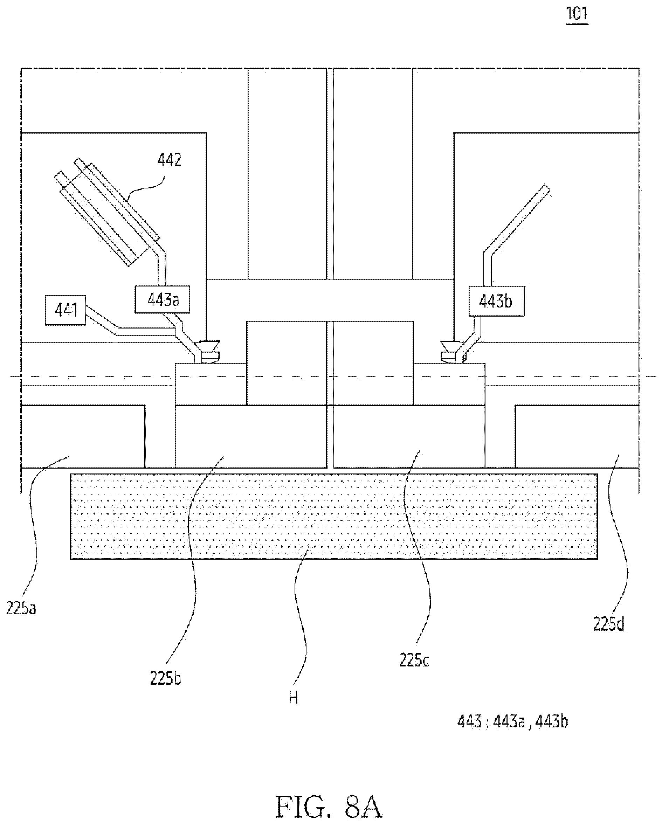

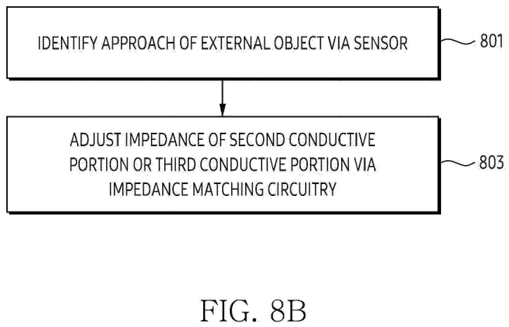

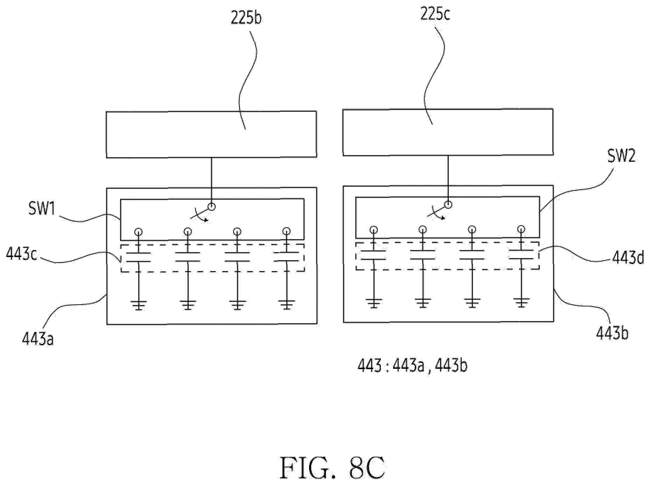

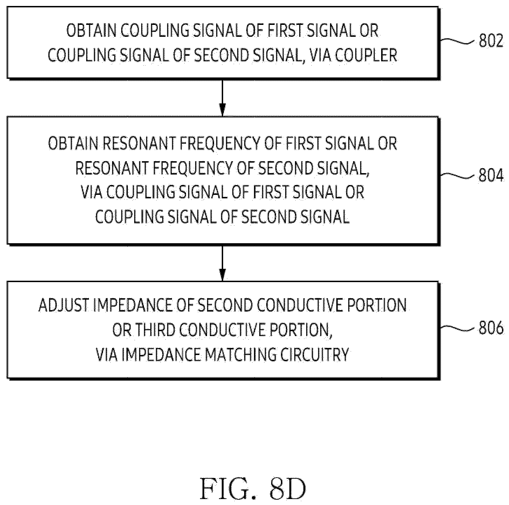

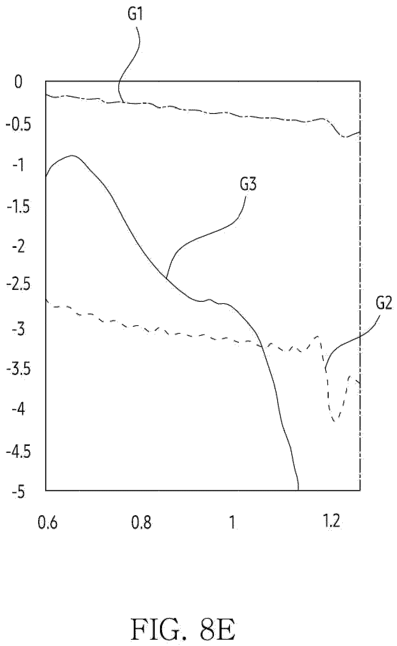

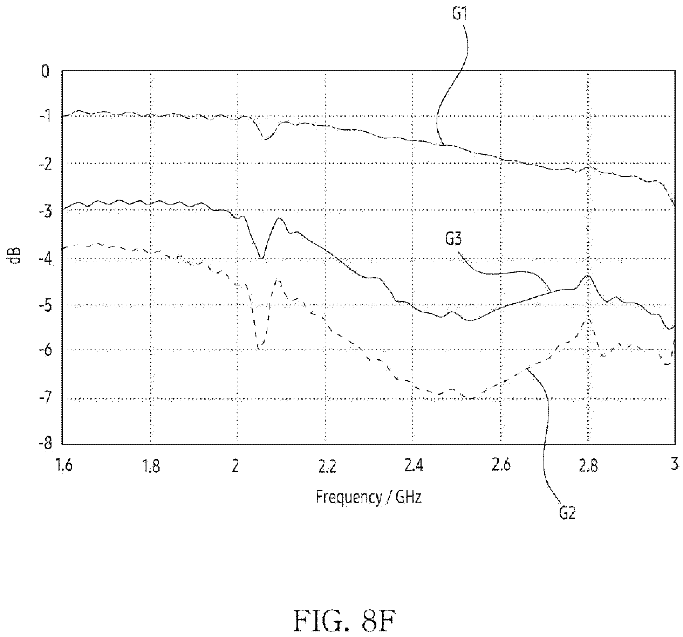

FIG. 8A illustrates a portion of an exemplary electronic device 100 used as a signal path. FIG. 8B is a flowchart illustrating an operation of at least one processor 120 when an external object H approaches. FIG. 8C schematically illustrates impedance matching circuitry 443. FIG. 8D is a flowchart illustrating an operation of at least one processor 120 when an external object H approaches. FIG. 8E illustrates a radiation characteristic of an antenna in a relatively low frequency band. FIG. 8F illustrates a radiation characteristic of an antenna in a relatively high frequency band.

Referring to FIG. 8A, an electronic device 101 according to an embodiment may include a sensor 441 for identifying an approach of the external object H to the electronic device 101. When a user uses the electronic device 101, the user may hold a side surface of the electronic device 101 while using it. When the side surface of the electronic device 101 is in contact with or close to the user's body, a change in impedance of a conductive portion forming the side surface may occur. For example, when a first conductive portion 225a, a second conductive portion 225b, a third conductive portion 225c, and/or a fourth conductive portion 225d are in contact with or close to the user's body, due to a high relative permittivity (e.g., 40) of the body, an impedance value of the first conductive portion 225a, the second conductive portion 225b, the third conductive portion 225c, and/or the fourth conductive portion 225d may lower. When the impedance value of the second conductive portion 225b and/or the third conductive portion 225c, used as a path for a first signal and/or a path for a second signal, is decreased, as a characteristic of an electromagnetic field formed by the second conductive portion 225b and/or the third conductive portion 225c is changed, communication performance of the electronic device 101 may be deteriorated. The electronic device 101 according to an embodiment may include impedance matching circuitry 443 to compensate for an impedance change of the second conductive portion 225b and/or the third conductive portion 225c due to the external object H. In an embodiment, the impedance matching circuitry 443 may be electrically connected to the second conductive portion 225b and the third conductive portion 225c.

Referring to FIG. 8B, in operation 801, at least one processor (e.g., the at least one processor 120 of FIG. 3A) may identify an approach of the external object H via the sensor 441. The electronic device 101 according to an embodiment may include the sensor 441 for identifying an approach of the external object H. For example, the sensor 441 may be configured to identify the approach of the external object H, based on a change in capacitance of the first conductive portion 225a, the second conductive portion 225b, the third conductive portion 225c, and/or the fourth conductive portion 225d. For example, the sensor 441 may be configured to identify the approach of the external object H based on identifying that the change in capacitance of the first conductive portion 225a, the second conductive portion 225b, the third conductive portion 225c, and/or the fourth conductive portion 225d is out of a designated reference range. The sensor 441 may be operatively connected to the at least one processor 120. The sensor 441 may be configured to provide a signal for notifying occurrence of the approach of the external object H to the at least one processor 120, based on identifying the approach of the external object H. The at least one processor 120 may identify the approach of the external object H, based on receiving the signal.

In operation 803, the at least one processor 120 may adjust the impedance of the second conductive portion 225b and/or the third conductive portion 225c via the impedance matching circuitry 443. When the impedance of the second conductive portion 225b and the third conductive portion 225c, used as the path for the first signal and/or the path of the second signal, is changed, the first signal and/or the second signal may be distorted. For example, as the external object H (e.g., the user's hand) approaches the second conductive portion 225b and/or the third conductive portion 225c, an impedance value of the second conductive portion 225b and an impedance value of the third conductive portion 225c may be out of the designated impedance value (e.g., 50 ohms). The at least one processor 120 may control the impedance matching circuitry 443 electrically connected to the second conductive portion 225b and/or the third conductive portion 225c so that the impedance value of the second conductive portion 225b and/or the impedance value of the third conductive portion 225c have a designated impedance value.

Referring to FIG. 8C, the impedance matching circuitry 443 may include an aperture tuner that includes at least one switch and a passive components connectable to the at least one switch. For example, the impedance matching circuitry 443 may include a plurality of capacitors and a plurality of inductors, but is not limited thereto.

Referring to FIG. 8C, the impedance matching circuitry 443 may include first impedance matching circuitry 443a connected to the second conductive portion 225b and second impedance matching circuitry 443b connected to the third conductive portion 225c. In an embodiment, the first impedance matching circuitry 443a may include a first aperture tuner 443c that includes a first switch SW1 and a plurality of passive components connectable to the second conductive portion 225b via the first switch SW1. For example, the first switch SW1 may be a single pole four through (SP4T) switch. The plurality of passive components may be a plurality of capacitors. However, the disclosure is not limited thereto. In an embodiment, the second impedance matching circuitry 443b may include a second aperture tuner 443d that includes a second switch SW2 and a plurality of passive components connectable to the third conductive portion 225c via the second switch SW2. Each of the plurality of capacitors may have different capacitance values. The first switch SW1 and the second switch SW2 may be operatively connected to the at least one processor 120.

In operation 803, the at least one processor 120 may connect the first switch SW1 to one of the plurality of capacitors to adjust an impedance value of the second conductive portion 225b. For example, the at least one processor 120 may control the first switch SW1, based on identifying that the impedance value of the second conductive portion 225b is out of a designated impedance value (e.g., 50 ohms). For example, the at least one processor 120 may control the first switch SW1 based on identifying that the impedance value of the second conductive portion 225b is reduced so that a capacitor capable of compensating for the reduced impedance value and the second conductive portion 225b are electrically connected. The at least one processor 120 may electrically connect the second switch SW2 to one of the plurality of capacitors to adjust the impedance value of the third conductive portion 225c. The impedance matching circuitry 443 illustrated in FIG. 8C is exemplary and is not limited thereto. For example, the impedance matching circuitry 443 may include a variable capacitor and/or a variable inductor. The at least one processor 120 may adjust the impedance value of the second conductive portion 225b and/or the third conductive portion 225c by adjusting a capacitance value of the variable capacitor or an inductance value of the variable inductor.

Referring back to FIG. 8A, the electronic device 101 according to an embodiment may include a coupler 442 for obtaining a coupling signal of the first signal and/or a coupling signal of the second signal. The coupler 442 may be used to obtain a coupling signal of the first signal that is a part of the first signal and/or a coupling signal of the second signal that is a part of the second signal. The at least one processor 120 may be configured to control the impedance matching circuitry 443 based on the coupling signal of the first signal and/or the coupling signal of the second signal.

Referring to FIG. 8D, in operation 802, the at least one processor 120 may obtain the coupling signal of the first signal and/or the coupling signal of the second signal via the coupler 442. For example, the coupling signal of the first signal may be a part of the first signal. The coupling signal of the first signal may indicate a transmission state of the first signal. For example, the coupling signal of the first signal may indicate whether the first signal has a frequency within a targeted frequency range. The coupling signal of the second signal may be a part of the second signal. The coupling signal of the second signal may indicate a transmission state of the second signal. For example, the coupling signal of the second signal may indicate whether the second signal has a frequency within a target frequency range.

In operation 804, the at least one processor 120 may obtain a resonant frequency of the first signal and/or a resonant frequency of the second signal via the coupling signal of the first signal and/or the coupling signal of the second signal. For example, the at least one processor 120 may identify the resonant frequency of the first signal via the obtained coupling signal of the first signal. The at least one processor 120 may identify the resonant frequency of the second signal via the obtained coupling signal of the second signal. When the impedance value of the second conductive portion 225b and/or the impedance value of the third conductive portion 225c have a designated impedance value (e.g., 50 ohms), the resonant frequency of the first signal and/or the resonant frequency of the second signal may have a resonant frequency within a target frequency range. For example, when the second conductive portion 225b and/or the third conductive portion 225c approach an external object H (e.g., the user's body), as the impedance value of the second conductive portion 225b and/or the impedance value of the third conductive portion 225c change, the resonance frequency of the first signal and/or the resonance frequency of the second signal may not have a resonance frequency within the target frequency range.

In operation 806, the at least one processor 120 may adjust impedance of the second conductive portion 225b and/or the third conductive portion 225c via the impedance matching circuitry 443. Operation 806 may be referred to as operation 803 of FIG. 8B.

FIGS. 8E and 8F illustrate a radiation characteristic of an antenna according to compensation for an impedance value by the impedance matching circuitry 443. The antenna may be referred to as an antenna including the fourth conductive portion 225d and/or the fifth conductive portion 225e. FIG. 8E illustrates a radiation characteristic of the antenna within a low band, and FIG. 8F illustrates a radiation characteristic of the antenna within a middle band and a high band.

Referring to FIGS. 8E and 8F, a first graph G1 indicates a radiation characteristic of the antenna in a state that an external object (e.g., the external object H of FIG. 8A) is not approached. A second graph G2 indicates a radiation characteristic of the antenna in a state that the antenna and the user's body are in contact with each other. A third graph G3 indicates a radiation characteristic of the antenna when an impedance value is compensated by impedance matching circuitry (e.g., the impedance matching circuitry 443 of FIG. 8A).

Referring to the first graph G1 and the second graph G2, a gain of the antenna may be lowered within a state that the antenna and the user's body are in contact. For example, when the user holds an electronic device (e.g., electronic device 101 of FIG. 8A) by hand and uses it, the gain of the antenna may be lowered by a change in impedance of a second conductive portion (e.g., the second conductive portion 225b of FIG. 8A) and/or a third conductive portion (e.g., the third conductive portion 225c of FIG. 8A) that provides a path for the first signal and/or the second signal. At least one processor (e.g., the at least one processor 120 in FIG. 3A) may adjust the impedance value of the second conductive portion 225b and/or the third conductive portion 225c via the impedance matching circuitry 443, based on identifying contact of the user's hand via a sensor (e.g., the sensor 441 of FIG. 8A), or identifying a change in a resonant frequency of the first signal and/or the second signal via a coupler (e.g., the coupler 442 of FIG. 8A). Referring to the third graph G3, as the impedance value of the second conductive portion 225b and/or the third conductive portion 225c is adjusted by the impedance matching circuitry 443, the gain of the antenna may be increased.

According to an embodiment, since the second conductive portion 225b and/or the third conductive portion 225c exposed to the outside of the electronic device 101 may be used as a path for the first signal and/or a path for the second signal, the second conductive portion 225b and the third conductive portion 225c may be affected by the external object H. According to an embodiment, the at least one processor 120 may compensate for the impedance value of the second conductive portion 225b and/or the impedance value of the third conductive portion 225c changed by the external object H, by adjusting the impedance value of the second conductive portion 225b and/or the impedance value of the third conductive portion 225c. Through the impedance matching circuit 443, the electronic device 101 according to an embodiment may stably communicate with an external electronic device via the second conductive portion 225b and/or the third conductive portion.

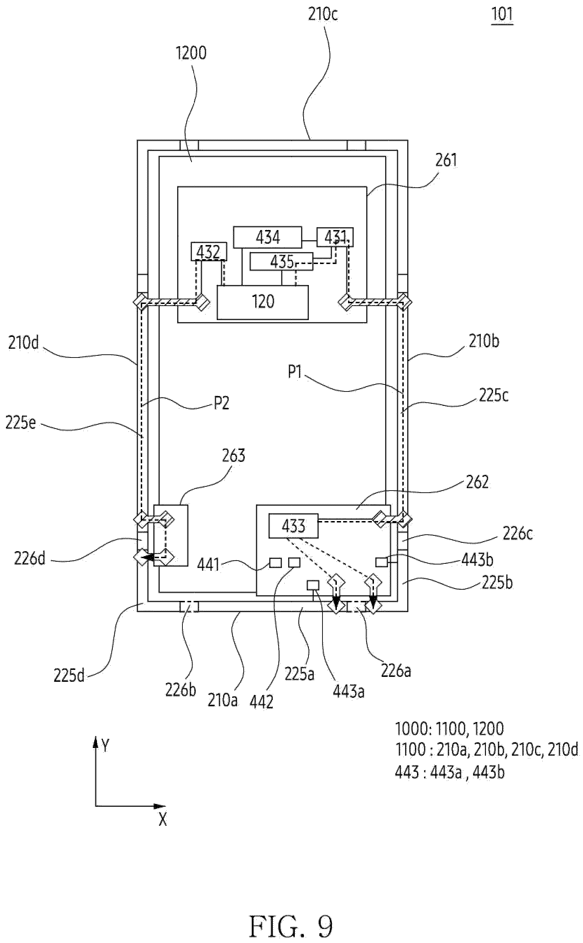

FIG. 9 schematically shows an exemplary electronic device 101.

Referring to FIG. 9, an electronic device 101 according to an embodiment may include a housing 1000, a first PCB 261, and at least one processor 120. The electronic device 101 illustrated in FIG. 9 may include substantially the same components as the electronic device 101 illustrated in FIG. 3A. The same components are described with the same reference numerals, and redundant descriptions may be omitted.

According to an embodiment, the housing 1000 may include a lateral member 1100 and a support member 1200. The lateral member 1100 may include a plurality of peripheries 210a, 210b, 210c, and 210d. For example, the lateral member 1100 may include a first periphery 210a, a second periphery 210b extending perpendicular to the first periphery 210a from an end of the first periphery 210a, a third periphery 210c opposite the first periphery 210a, and a fourth periphery 210d opposite the second periphery 210b. For example, the first periphery 210a may be a periphery of the housing 210 in -y direction. The second periphery 210b may be a periphery of the housing 210 in +x direction. The third periphery 210c may be a periphery of the housing 210 in +y direction. The fourth periphery 210d may be a periphery of the housing 210 in -x direction. However, the disclosure is not limited thereto.

According to an embodiment, the support member 1200 and the lateral member 1100 may be at least partially spaced apart from each other. For example, at least a portion of the spaced apart portion may be filled with a non-conductive material (e.g., resin). According to an embodiment, the first PCB 261 may be disposed in the housing 1000. According to an embodiment, the at least one processor 120 may be disposed on the first PCB 261. In the housing 1000, the first PCB 261 may be disposed closer to the third periphery 210c from among the first periphery 210a and the third periphery 210c.

For example, at least one processor 120, a first PAM 434, a second PAM 435, a first filter 431, and/or a second filter 432 may be disposed on the first PCB 261. The at least one processor 120 may be configured to receive and/or transmit a wireless communication signal. The at least one processor 120 may be electrically connected to the first PAM 434 and/or the second PAM 435 for setting transmission power of a first signal transmitted to an external electronic device and/or a second signal received from an external electronic device. The first filter 431 and the second filter 432 may be configured to filter a signal having a designated frequency range. For example, the first filter 431 and the second filter 432 may pass a signal having a designated frequency range. The first filter 431 and the second filter 432 may be configured to block a signal having a frequency range other than the designated frequency range.

According to an embodiment, the lateral member 1100 may include a first conductive portion 225a, a second conductive portion 225b, and a third conductive portion 225c. For example, the first conductive portion 225a may extend from a first non-conductive portion 226a within the first periphery 210a to a second non-conductive portion 226b within the first periphery 210a. For example, the second conductive portion 225b may extend from the first non-conductive portion 226a to a third non-conductive portion 226c within the second periphery 210b. For example, the third conductive portion 225c may extend from the third non-conductive portion 226c along a portion of the second periphery 210b.

According to an embodiment, the at least one processor 120 may communicate with an external electronic device by feeding power to at least one of conductive portions of the lateral member 1100. The conductive portions may operate as an antenna by being fed by the at least one processor 120. Through the conductive portions, the at least one processor 120 may transmit a signal to an external electronic device or receive a signal from an external electronic device.

According to an embodiment, the first conductive portion 225a and/or the second conductive portion 225b may operate as an antenna by being fed by the at least one processor 120. Since the at least one processor 120 is disposed relatively far from the first periphery 210a, a path of a signal for transmitting a signal to the first conductive portion 225a and/or the second conductive portion 225b or receiving a signal from the first conductive portion 225a and/or the second conductive portion 225b may be required.

According to an embodiment, the third conductive portion 225c may be electrically connected to the first conductive portion 225a and the second conductive portion 225b. For example, the third conductive portion 225c may be used as a path P1 of a first signal provided from the at least one processor 120 to at least one of the first conductive portion 225a and/or the second conductive portion 225b, and/or a path P1 of a second signal provided to the at least one processor 120 from the first conductive portion 225a or the second conductive portion 225b.

For example, when the at least one processor 120 transmits the first signal via the first conductive portion 225a and/or the second conductive portion 225b, the first signal may be provided from the at least one processor 120 to the third conductive portion 225c via the first PCB 261. For example, the first filter 431 on the first PCB 261 may be electrically connected to the third conductive portion 225c. The first signal may be provided to the third conductive portion 225c via the first filter 431. The first signal may be provided to the first conductive portion 225a and/or the second conductive portion 225b via the third conductive portion 225c electrically connected to the first conductive portion 225a and the second conductive portion 225b.

For example, the electronic device 101 may include a second PCB 262 and a third filter 433. For example, the second PCB 262 may be disposed closer to the first periphery 210a from among the first periphery 210a and the third periphery 210c. The third filter 433 may be electrically connected to the first conductive portion 225a and the second conductive portion 225b. The third filter 433 may be configured to transfer the first signal to the first conductive portion 225a and/or the second conductive portion 225b, based on a resource frequency of the first signal. The first signal provided to the first conductive portion 225a and/or the second conductive portion 225b may be transmitted to the outside of the electronic device 101 via the first conductive portion 225a and/or the second conductive portion 225b.

According to an embodiment, a length of the first conductive portion 225a may be different from a length of the second conductive portion 225b. For example, the length of the second conductive portion 225b may be shorter than the length of the first conductive portion 225a, but is not limited thereto. A resonant frequency of the antenna including the first conductive portion 225a or the second conductive portion 225b may be determined based on the length of the first conductive portion 225a or the length of the second conductive portion 225b. For example, when the length of the second conductive portion 225b is shorter than the length of the first conductive portion 225b, a resonant frequency of the second conductive portion 225a may be greater than a resonant frequency of the first conductive portion 225a. The third filter 433 may be configured to provide the first signal to the first conductive portion 225a and/or the second conductive portion 225b, based on the resource frequency of the first signal.

For example, when the at least one processor 120 receives a second signal via the first conductive portion 225a and/or the second conductive portion 225b, the second signal may be provided from the first conductive portion 225a and/or the second conductive portion 225b to the third filter 433. The second signal may be provided to the third conductive portion 225c via the third filter 433. The second signal provided to the third conductive portion 225c may be provided to the at least one processor 120 via the first PCB 261.

According to an embodiment, the lateral member 1100 may include a fourth conductive portion 225d and a fifth conductive portion 225e. The fourth conductive portion 225d may extend from a second non-conductive portion 226b to a fourth non-conductive portion 226d in the fourth periphery 210d. The fifth conductive portion 225e may extend from the fourth non-conductive portion 226d along a portion of the fourth periphery 210d. According to an embodiment, the fifth conductive portion 225e may be electrically connected to the fourth conductive portion 225d. For example, the electronic device 101 may include a third PCB 263 electrically connected to the fourth conductive portion 225d and the fifth conductive portion 225e. The fifth conductive portion 225e may be used as a path P2 of the first signal provided from the at least one processor 120 to the fourth conductive portion 225d and/or a path P2 of the second signal provided from the fourth conductive portion 225d to the at least one processor 120.

For example, when the at least one processor 120 transmits the first signal via the fourth conductive portion 225d, the first signal may be provided from the at least one processor 120 to the fifth conductive portion 225e via the first PCB 261. For example, the first signal may be provided to the fifth conductive portion 225e via the second filter 432 on the first PCB 261. The first signal may be provided to the fourth conductive portion 225d via the fifth conductive portion 225e electrically connected to the fourth conductive portion 225d. The first signal provided to the fourth conductive portion 225d may be transmitted to the outside of the electronic device 101 via the fourth conductive portion 225d.

For example, when the at least one processor 120 receives a second signal via the fourth conductive portion 225d, the second signal may be provided from the fourth conductive portion 225d to the fifth conductive portion 225e via the second PCB 262. The second signal may be provided to the first PCB 261 via the fifth conductive portion 225e. The at least one processor 120 may receive the second signal via the first PCB 261.

Referring to FIG. 9, the electronic device may comprise impedance matching circuitry 443, a sensor 441, and/or a coupler 442. The impedance matching circuitry 443 may be electrically connected to the first conductive portion 225a and the second conductive portion 225b. For example, the impedance matching circuitry 443 may include first impedance matching circuitry 443a electrically connected to the first conductive portion 225a and second impedance matching circuitry 443b electrically connected to the second conductive portion 225b. The sensor 441 may identify an approach of the external object H to the electronic device 101. For example, the sensor 441 may identify the approach of the external object H via a change in an impedance value of the lateral member 1100. The coupler 442 may obtain a coupling signal of the first signal and/or a coupling signal of the second signal.

According to an embodiment, the at least one processor 120 may be configured to adjust impedance of the first conductive portion 225a and/or the second conductive portion 225b via the impedance matching circuitry 443, based on identifying the approach of the external object H via the sensor 441. The operation of the at least one processor 120 may be referred to as operation 801 and operation 803.

According to an embodiment, the at least one processor 120 may be configured to adjust impedance of the first conductive portion 225a or the second conductive portion 225b via the impedance matching circuitry 443, based on the coupling signal of the first signal and/or the coupling signal of the second signal. The operation of the at least one processor 120 may be referred to as operation 802, operation 804, and operation 806.

An electronic device (e.g., the electronic device 101 of FIG. 3A) according to an embodiment may include a first housing (e.g., the first housing 210 of FIG. 3A), a second housing (e.g., the second housing 220 of FIG. 3A), a display (e.g., the display 230 of FIG. 3A), a connecting structure (e.g., the connecting structure 300 of FIG. 3B), and at least one processor (e.g., the at least one processor 120 of FIG. 3B). The first housing may include at least one first PCB (e.g., the at least one first PCB 261 of FIG. 3B). The second housing may be rotatably connected to the first housing with respect to a folding axis (e.g., the folding axis f of FIG. 3B). The display may include a first display area (e.g., the first display area 231 of FIG. 3A), a second display area (e.g., the second display area 232 of FIG. 3A), and a third display area (e.g., the third display area 233 of FIG. 3A). The first display area may be disposed on the first housing. The second display area may be disposed on the second housing. The third display area may be disposed between the first display area and the second display area. The connecting structure may be disposed across the folding axis. The at least one processor may be disposed on the at least one first PCB. The first housing may include a first conductive portion (e.g., the first conductive portion 225a of FIG. 3B) and a second conductive portion (e.g., the second conductive portion 225b of FIG. 3B). The first conductive portion and the second conductive portion may be disposed at a first periphery (e.g., the first periphery 210a of FIG. 3B) of the first housing perpendicular to the folding axis from among peripheries of the first housing. The second housing may include a third conductive portion (e.g., the third conductive portion 225c of FIG. 3B) and a fourth conductive portion (e.g., the fourth conductive portion 225d of FIG. 3B). The third conductive portion and the fourth conductive portion may be disposed at a second periphery (e.g., the second periphery 220a of FIG. 3B) of the second housing among the peripheries of the second housing, the second periphery facing the first periphery of the first housing when a first direction of the first display area is opposite to a second direction of the second display area. The connecting structure may electrically connect the second conductive portion and the third conductive portion. The connecting structure may be electrically connected to the fourth conductive portion. The connecting structure may be used as a path for a first signal provided from the at least one processor to the fourth conductive portion. The connecting structure may be used as a path for a second signal provided from the fourth conductive portion to the at least one processor. According to an embodiment of the present disclosure, even when the electronic device does not include an additional component (e.g., coaxial cables, flexible PCB) for a transmission path of a signal across the first housing and the second housing, the at least one processor in the first housing may be electrically connected to a conductive portion of the second housing via a physical configuration (e.g., the second conductive portion) of the first housing, a physical configuration (e.g., the third conductive portion) of the second housing, and a connecting structure. When the conductive portion of the second housing operates as an antenna, as the connecting structure provides a transmission path of the signal, the electronic device according to an embodiment may communicate with an external electronic device via the conductive portion of the second housing.

According to an embodiment, the first housing may include a first support member (e.g., the first support member 215 of FIG. 5A). The first support member may be disposed in the first housing. The first support member may be at least partially separated from the peripheries of the first housing. The second housing may include a second support member (e.g., the second support member 227 of FIG. 5A). The second support member may be disposed in the second housing. The second support member may be at least partially separated from the peripheries of the second housing. The display may be electrically connected to the connecting structure. The display may be electrically disconnected from the first conductive portion, the second conductive portion, the third conductive portion, and the fourth conductive portion. According to an embodiment of the present disclosure, the display may be electrically connected to the connecting structure, thereby being electrically integrally operated with the connecting structure. The display may be electrically disconnected from the first conductive portion, the second conductive portion, the third conductive portion, and the fourth conductive portion. According to an embodiment, influence on the first signal and/or the second signal of the display may be reduced.

According to an embodiment, a first width (e.g., the first width L1 of FIG. 5A) of the first conductive portion may be proportional to a first gap (e.g., the first gap g1 of FIG. 5A) between the first support member and the second conductive portion. A second width (e.g., the second width L2 of FIG. 5A) of the second conductive portion may be proportional to a second gap (e.g., the second gap g2 of FIG. 5A) between the second support member and the third conductive portion.

According to an embodiment, a first thickness (e.g., the first thickness t1 of FIG. 5B) corresponding to a sum of a thickness of the second conductive portion and a thickness of the connecting structure may be proportional to the first gap between the first support member and the second conductive portion. A second thickness (e.g., the second thickness t2 of FIG. 5B) corresponding to a sum of a thicknesses of the third conductive portion and a thickness of the connecting structure may be proportional to a second gap between the second support member and the third conductive portion. According to an embodiment of the present disclosure, the second conductive portion and/or the third conductive portion may be used as a path for the first signal and/or a path for the second signal. An impedance value of the second conductive portion and/or an impedance value of the third conductive portion may be designed within a designated impedance value range to implement a transmission path of the signal via the second conductive portion and/or the third conductive portion.

According to an embodiment, the connecting structure may overlap at least a portion of the second conductive portion when the first periphery is viewed in a direction parallel to the folding axis. The connecting structure may overlap at least a portion of the third conductive portion when the second periphery is viewed in a direction parallel to the folding axis. According to an embodiment of the present disclosure, the connecting structure may electrically connect the second conductive portion and the third conductive portion by at least partially overlapping the second conductive portion and the third conductive portion.

According to an embodiment, the first signal may be provided from the at least one processor to the fourth conductive portion via the at least one first PCB, the second conductive portion, the connecting structure, and the third conductive portion. The second signal may be provided from the fourth conductive portion to the at least one processor via the third conductive portion, the connecting structure, the second conductive portion, and the at least one first PCB. According to an embodiment of the present disclosure, the connecting structure, the first conductive portion, and/or the second conductive portion may be used as a path for the first signal and/or a path for the second signal. The first signal may be provided from the at least one processor to the fourth conductive portion and/or the fifth conductive portion via the connecting structure, the first conductive portion, and the second conductive portion. The second signal may be provided to the at least one processor from the fourth conductive portion and/or the fifth conductive portion via the connecting structure, the first conductive portion, and the second conductive portion.

According to an embodiment, the electronic device may include a hinge structure (e.g., the hinge structure 250 of FIG. 6). The hinge structure may include a first hinge plate (e.g., the first hinge plate 252 of FIG. 6), a second hinge plate (e.g., the second hinge plate 253 of FIG. 6), and a third hinge plate (e.g., the third hinge plate 255 of FIG. 6). The first hinge plate may be connected to the second conductive portion. The second hinge plate may be connected to the third conductive portion. The third hinge plate may electrically connect the first hinge plate and the second hinge plate. The connecting structure may be included in the hinge structure. The second conductive portion and the third conductive portion may be electrically connected via the hinge structure.

According to an embodiment, the first hinge plate may be rotatably coupled to the third hinge plate with respect to a first axis (e.g., the first axis a1 of FIG. 6). The second hinge plate may be rotatably coupled to the third hinge plate with respect to a second axis (e.g., the second axis a2 of FIG. 6) distinct from the first axis. According to an embodiment of the present disclosure, a hinge structure disposed between the first housing and the second housing may be used as a path for the first signal and/or a path for the second signal.

According to an embodiment, the connecting structure may include a cap (e.g., the cap 410 of FIG. 7C). The cap may include a first cover (e.g., the first cover 411 of FIG. 7C), a second cover (e.g., the second cover 413 of FIG. 7C), and a conductive cover (e.g., the conductive cover 415 of FIG. 7C). The first cover may be accommodated in a first groove (e.g., the first groove gr1 of FIG. 7C) of the second conductive portion. The first cover may include a first ball bearing (e.g., the first ball bearing 412 of FIG. 7C). The second cover may be accommodated in a second groove (e.g., the second groove gr2 of FIG. 7C) of the third conductive portion. The second cover may include a second ball bearing (e.g., the second ball bearing 414 of FIG. 7C). The cap may be coupled to the first cover and the second cover. The conductive cover may cover the first groove and the second groove. The second conductive portion and the third conductive portion may be electrically connected via the first cover, the second cover, and the cap. According to an embodiment of the present disclosure, the cap disposed between the first housing and the second housing may be used as a path for the first signal and a path for the second signal. According to an embodiment of the present disclosure, a cap capable of preventing the inflow of foreign substances (e.g., dust) between the first housing and the second housing may be used as a path for the first signal and/or a path for the second signal.

According to an embodiment, the second housing may include a fifth conductive portion (e.g., the fifth conductive portion 225e of FIG. 3B) and a filter (e.g., the second filter 432 of FIG. 3B). The fifth conductive portion may be electrically disconnected from the fourth conductive portion. The filter may be configured to provide the first signal to the fourth conductive portion or the fifth conductive portion, based on a resonant frequency of the first signal. According to an embodiment of the present disclosure, a length of the fourth conductive portion may be different from a length of the fifth conductive portion. A radiation characteristic of the fourth conductive portion may be different from a radiation characteristic of the fifth conductive portion. The filter may transmit the first signal to the fourth conductive portion and/or the fifth conductive portion based on the resonant frequency of the first signal. According to an embodiment, the first signal may be transmitted to an external electronic device via the fourth conductive portion and/or the fifth conductive portion, based on the radiation characteristic of the antenna.

According to an embodiment, the second housing may include a second PCB (e.g., the second PCB 262 of FIG. 3B). The second PCB may be disposed in the second housing. The second PCB may be spaced apart from the at least one first PCB. The first signal may be provided to the second PCB via the third conductive portion, and may be provided to the fourth conductive portion via the second PCB. The second signal may be provided to the second PCB via the fourth conductive portion, and may be provided to the third conductive portion via the second PCB. According to an embodiment of the present disclosure, the second PCB may be disposed in the second housing. The second PCB may provide the first signal provided from the third conductive portion to the fourth conductive portion and/or the sixth conductive portion, or the second signal provided from the fourth conductive portion and/or the sixth conductive portion to the third conductive portion.

According to an embodiment, the at least one first PCB may include a main PCB (e.g., the main PCB 261a of FIG. 3B) and a sub-PCB (e.g., the sub-PCB 261b of FIG. 3B). The at least one processor may be disposed on the main PCB. The main PCB may be positioned closer to a third periphery (e.g., the third periphery 210b of FIG. 3B) opposite the first periphery from among the first periphery and the third periphery. The sub-PCB may be positioned closer to the first periphery from among the first periphery and the third periphery.

According to an embodiment, the main PCB may be electrically connected to the sub-PCB via a cable (e.g., the cable C of FIG. 3B). The sub-PCB may be electrically connected to the first conductive portion and the second conductive portion. According to an embodiment of the present disclosure, the first housing may include a plurality of PCBs. For example, the main PCB on which the at least one processor is disposed may be disposed on a side of the housing, and the sub-PCB may be disposed on another side of the housing. When the at least one processor transmits and/or receives a signal, the signal may be provided via a cable between the main PCB and the sub-PCB.

The electronic device according to an embodiment may further include a sensor (e.g., the sensor 441 of FIG. 8A) and impedance matching circuitry (e.g., the impedance matching circuitry 443 of FIG. 8A). The sensor may be operatively connected to the at least one processor. The sensor may be configured to identify an approach of an external object, based on a change in capacitance of the first conductive portion, the second conductive portion, the third conductive portion, or the fourth conductive portion. The impedance matching circuitry may be electrically connected to the second conductive portion and the third conductive portion. The at least one processor may be configured to adjust the impedance of the second conductive portion or the third conductive portion via the impedance matching circuitry, based on identifying an approach of an external object via the sensor.

The electronic device according to an embodiment may further include a coupler (e.g., the coupler 442 of FIG. 8A) and impedance matching circuitry. The coupler may be configured to obtain a coupling signal of the first signal or a coupling signal of the second signal. The impedance matching circuitry may be electrically connected to the second conductive portion and the third conductive portion. The at least one processor may be configured to obtain, via the coupler, the coupling signal of the first signal or the coupling signal of the second signal. The at least one processor may be configured to adjust the impedance of the second conductive portion or the third conductive portion through the impedance matching circuitry, based on the coupling signal of the first signal or the coupling signal of the second signal. When the electronic device approaches an external object, wireless communication performance may deteriorate. For example, when a user holds and uses an electronic device, a change in a capacitance value of a lateral member may occur. The change in the capacitance value may distort a wireless communication signal. According to an embodiment of the present disclosure, the at least one processor may control the impedance matching circuitry to maintain the impedance of the second conductive portion and/or the third conductive portion, used as a transmission path of the signal, within a designated impedance value (e.g., 50 ohms). The impedance matching circuitry may maintain the impedance of the second conductive portion and/or the third conductive portion within a designated impedance value range. The electronic device according to an embodiment may stably perform wireless communication even when approaching an external object.

An electronic device (e.g., the electronic device 101 of FIG. 9) according to an embodiment may include a housing (e.g., the housing 1000 of FIG. 9), a first PCB (e.g., the first PCB 261 of FIG. 9), and at least one processor (e.g., the at least one processor 120 of FIG. 9). The housing may include a lateral member (e.g., the lateral member 1100 of FIG. 9) and a support member (e.g., the support member 1200 of FIG. 9). The lateral member may include a first periphery (e.g., the first periphery 210a of FIG. 9), a second periphery (e.g., the second periphery 210b of FIG. 9) opposite the first periphery, a third periphery (e.g., the third periphery 210c of FIG. 9) extending from an end of the first periphery to an end of the second periphery, and a fourth periphery (e.g., the fourth periphery 210d of FIG. 9) opposite to the third periphery. The support member may be spaced apart from the lateral member. The first PCB may be disposed closer to the third periphery from among the first periphery and the third periphery. The at least one processor may be disposed on the first PCB. The lateral member may include a first conductive portion (e.g., the first conductive portion 225a of FIG. 9), a second conductive portion (e.g., the second conductive portion 225b of FIG. 9), and a third conductive portion (e.g., the third conductive portion 225c of FIG. 9). The first conductive portion may extend from a first non-conductive portion (e.g., the first non-conductive portion 226a of FIG. 9) in the first periphery to a second non-conductive portion (e.g., the second non-conductive portion 226b of FIG. 9) in the first periphery. The second conductive portion may extend from the first non-conductive portion to a third non-conductive portion (e.g., the third non-conductive portion 226c of FIG. 9) in the second periphery. The third conductive portion may extend from the third non-conductive portion along a portion of the second periphery. The third conductive portion may be electrically connected to the first conductive portion and the second conductive portion. The third conductive portion may be used as a path for a first signal provided from the at least one processor to the first conductive portion or the second conductive portion. The third conductive portion may be used as a path for a second signal provided from the first conductive portion or the second conductive portion to the at least one processor. According to an embodiment of the present disclosure, the at least one processor may be configured to communicate with an external electronic device via the conductive portion of the lateral member. The at least one processor may require a signal transmission path to provide a signal to the spaced conductive portion, because it is disposed on the first PCB. According to an embodiment, the conductive portion of the lateral member may be utilized as a signal transmission path. According to an embodiment, the at least one processor may provide a signal to the lateral member or receive a signal from the lateral member, even without an additional component (e.g., coaxial cable, flexible PCB) for signal transmission.

According to an embodiment, the lateral member may include a fourth conductive portion (e.g., the fourth conductive portion 225d of FIG. 9) and a fifth conductive portion (e.g., the fifth conductive portion 225e of FIG. 9). The fourth conductive portion may extend from the second non-conductive portion to a fourth non-conductive portion (e.g., the fourth non-conductive portion 226d of FIG. 9) in the fourth periphery. The fifth conductive portion may extend from the fourth non-conductive portion along a portion of the fourth periphery. The fifth conductive portion may be electrically connected to the fourth conductive portion. The fifth conductive portion may be used as a path for a first signal provided from the at least one processor to the fourth conductive portion. The fifth conductive portion may be used as a path for a second signal provided from the fourth conductive portion to the at least one processor.

The electronic device according to an embodiment may further include a sensor (e.g., the sensor 441 of FIG. 9) and impedance matching circuitry (e.g., the impedance matching circuitry 443 of FIG. 9). The sensor may be operatively connected to the at least one processor. The sensor may be configured to identify an approach of an external object, based on a change in capacitance of the first conductive portion, the second conductive portion, or the third conductive portion. The impedance matching circuitry may be electrically connected to the first conductive portion and the second conductive portion. The at least one processor may be configured to adjust an impedance of the first conductive portion or the second conductive portion via the impedance matching circuitry, based on identifying an approach of an external object through the sensor.

The electronic device according to an embodiment may further include a coupler (e.g., the coupler 442 of FIG. 9) and impedance matching circuitry. The coupler may be configured to obtain a coupling signal of the first signal or a coupling signal of the second signal. The impedance matching circuitry may be electrically connected to the first conductive portion and the second conductive portion. The at least one processor may be configured to obtain, via the coupler, the coupling signal of the first signal or the coupling signal of the second signal. The at least one processor may be configured to adjust an impedance of the first conductive portion or the second conductive portion via the impedance matching circuitry, based on the coupling signal of the first signal or the coupling signal of the second signal. When the electronic device approaches an external object, the wireless communication performance may deteriorate. For example, when a user holds and uses the electronic device, a change in a capacitance value of the lateral member may occur. The change in the capacitance value may distort the wireless communication signal. According to an embodiment of the present disclosure, the at least one processor may control impedance matching circuitry to maintain an impedance of the second conductive portion and/or the third conductive portion used as a signal transmission path within a range of a designated impedance value (e.g., 50 ohms). The impedance matching circuitry may maintain the impedance of the second conductive portion and/or the third conductive portion within a range of a designated impedance value. The electronic device according to an embodiment may perform stably wireless communication even when approaching an external object.

The electronic device according to an embodiment may further include a second PCB (e.g., the second PCB 262 of FIG. 9) and a filter (e.g., the third filter 433 of FIG. 9). According to an embodiment, the second PCB may be positioned closer to the first periphery among the first periphery and the third periphery. The filter may be disposed on the second PCB. The filter may be configured to provide the first signal to the first conductive portion or the second conductive portion, based on a resonant frequency of the first signal. According to an embodiment of the present disclosure, a length of the first conductive portion may be different from a length of the second conductive portion. A radiation characteristic of the first conductive portion may be different from a radiation characteristic of the second conductive portion. The filter may transfer the first signal to the first conductive portion and/or the second conductive portion, based on the resonant frequency of the first signal. According to an embodiment, based on the radiation characteristic of the antenna, the first signal may be transmitted to an external electronic device via the first conductive portion and/or the second conductive portion.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:

    a first housing including at least one first printed circuit board (PCB);
    a second housing rotatable relative to the first housing with respect to the folding axis;
    a display including:

       a first display area disposed on the first housing,
       a second display area disposed on the second housing, and
       a third display area between the first display area and the second display area;

    a connecting structure disposed across the folding axis; and
    at least one processor on the at least one first PCB,
    wherein the first housing includes a first conductive portion and a second conductive portion that are disposed at a first periphery perpendicular to the folding axis from among peripheries of the first housing,
    wherein the second housing includes a third conductive portion and a fourth conductive portion that are disposed at a second periphery of the second housing from among peripheries of the second housing, the second periphery facing the first periphery of the first housing when a first direction of the first display area is opposite to a second direction of the second display area, wherein the connecting structure electrically connects the second conductive portion and the third conductive portion and is electrically connected to the fourth conductive portion, and wherein the connecting structure is used as a path for a first signal provided from the at least one processor to the fourth conductive portion or a path for a second signal provided from the fourth conductive portion to the at least one processor.

2.   The electronic device of claim 1,

wherein the first housing includes a first support member, disposed in the first housing, at least partially separated from the peripheries of the first housing, wherein the second housing includes a second support member, disposed in the second housing, at least partially separated from the peripheries of the second housing, and wherein the display is electrically connected to the connecting structure and is electrically disconnected from the first conductive portion, the second conductive portion, the third conductive portion, and the fourth conductive portion.

3.   The electronic device of any one of claim 1 or 2,

wherein a first width of the first conductive portion is proportional to a first gap between the first support member and the second conductive portion, and wherein a second width of the second conductive portion is proportional to a second gap between the second support member and the third conductive portion.

4.   The electronic device of any one of claims 1 to 3,

wherein a first thickness corresponding to a sum of a thickness of the second conductive portion and a thickness of the connecting structure is proportional to the first gap between the first support member and the second conductive portion, and wherein a second thickness corresponding to a sum of a thickness of the third conductive portion and the thickness of the connecting structure is proportional to the second gap between the second support member and the third conductive portion.

5.   The electronic device of any one of claims 1 to 4,

wherein the connecting structure overlaps:

at least portion of the second conductive portion, when the first periphery is viewed from in a direction parallel to the folding axis, and at least portion of the third conductive portion, when the second periphery is viewed from in the direction parallel to the folding axis.

6.   The electronic device of any one of claims 1 to 5,

wherein the first signal is provided from the at least one processor to the fourth conductive portion, via the at least one first PCB, the second conductive portion, the connecting structure, and the third conductive portion, and wherein the second signal is provided from the fourth conductive portion to the at least one processor, via the third conductive portion, the connecting structure, the second conductive portion, and the at least one first PCB.

7.   The electronic device of any one of claims 1 to 6, further comprising a hinge structure including:

a first hinge plate connected to the second conductive portion, a second hinge plate connected to the third conductive portion, and a third hinge plate electrically connecting the first hinge plate and the second hinge plate, wherein the connecting structure is included in the hinge structure, and wherein the second conductive portion and the third conductive portion are electrically connected each other via the hinge structure.

8.   The electronic device of any one of claims 1 to 7,

wherein the first hinge plate is rotatably coupled to the third hinge plate with respect to a first axis, and wherein the second hinge plate is rotatably coupled to the third hinge plate with respect to a second axis distinct from the first axis.

9.   The electronic device of any one of claims 1 to 8,

wherein the connecting structure includes:

a first cover, accommodated in a first groove of the second conductive portion, including a first ball bearing, a second cover, accommodated in a second groove of the third conductive portion, including a second ball bearing, and a cap including a conductive cover coupled to the first cover and the second cover and covering the first groove and the second groove, and

wherein the second conductive portion and the third conductive portion are electrically connected each other via the first cover, the second cover, and the cap.

10. The electronic device of any one of claims 1 to 9 wherein the second housing includes:

a fifth conductive portion electrically disconnected from the fourth conductive portion, and a filter configured to provide the first signal to the fourth conductive portion or the fifth conductive portion, based on a resonant frequency of the first signal.

11. The electronic device of any one of claims 1 to 10,

wherein the second housing includes a second PCB, disposed in the second housing, spaced apart from the at least one first PCB, wherein the first signal is provided to the second PCB via the third conductive portion, and is provided to the fourth conductive portion via the second PCB, and wherein the second signal is provided to the second PCB via the fourth conductive portion, and is provided to the third conductive portion via the second PCB.

12. The electronic device of any one of claims 1 to 11, wherein the at least one first PCB includes:

a main PCB, on which the at least one first PCB is disposed, positioned closer to a third periphery opposite to the first periphery from among the first periphery and the third periphery, and a sub-PCB positioned closer to the first periphery from among the first periphery and the third periphery.

13. The electronic device of any one of claims 1 to 12,

wherein the main PCB is electrically connected to the sub-PCB via a cable, and wherein the sub-PCB is electrically connected to the first conductive portion and the second conductive portion.

14. The electronic device of any one of claims 1 to 13, further comprising:

a sensor, operatively connected to the at least one processor, for identifying an approach of an external object based on a change of capacitance of the first conductive portion, the second conductive portion, the third conductive portion, or the fourth conductive portion; and impedance matching circuitry electrically connected to the second conductive portion and the third conductive portion, wherein the at least one processor is configured to adjust an impedance of the second conductive portion or the third conductive portion, via the impedance matching circuitry, based on identifying the approach of the external object.

15. The electronic device of any one of claims 1 to 14, further comprising:

a coupler configured to obtain a coupling signal of the first signal or a coupling signal of the second signal; and impedance matching circuitry electrically connected to the second conductive portion and the third conductive portion; wherein the at least one processor is configured to:

obtain the coupling signal of the first signal or the coupling signal of the second signal, via the coupler, and adjust an impedance of the second conductive portion or the third conductive portion, via the impedance matching circuitry, based on the coupling signal of the first signal or the coupling signal of the second signal.

FIG. 1

FIG. 2A

FIG. 2B

FIG. 2C

101

210          220

231          233          230

230

231
210a

D1    250    f    D2

232
220a

FIG. 3A

FIG. 3B

FIG. 3C

FIG. 4A

FIG. 4B

101

261b    215    210    220    227    262

350    350

g1    g2

A    A'

L1    L2

B    B'

225a    214    225b    210a    225c    220a    224    225d

FIG. 5A

101

261b    215    227    262

A                                                    A'

230    351    400    352

350 : 351, 352

FIG. 5B

101

225b    225c

B                                    B'

t1    225b    225c    t2

230

400

FIG. 5C

FIG. 6

101

FIG. 7A

101

411

210

220

412   114

410

251

FIG. 7B

410(400)

412
415
414
411
413
P

gr1    417    418    gr2

225b    225c

FIG. 7C

441   442   443a   443b

225a   225b   H   225c   225d

443 : 443a , 443b

FIG. 8A

101

IDENTIFY APPROACH OF EXTERNAL OBJECT VIA SENSOR — 801

ADJUST IMPEDANCE OF SECOND CONDUCTIVE PORTION OR THIRD CONDUCTIVE PORTION VIA IMPEDANCE MATCHING CIRCUITRY — 803

FIG. 8B

FIG. 8C

```
┌─────────────────────────────────────────────────┐
│   OBTAIN COUPLING SIGNAL OF FIRST SIGNAL OR       │ ── 802
│ COUPLING SIGNAL OF SECOND SIGNAL, VIA COUPLER     │
└─────────────────────────────────────────────────┘
                        │
                        ▼
┌─────────────────────────────────────────────────┐
│   OBTAIN RESONANT FREQUENCY OF FIRST SIGNAL OR    │
│      RESONANT FREQUENCY OF SECOND SIGNAL,         │ ── 804
│     VIA COUPLING SIGNAL OF FIRST SIGNAL OR        │
│        COUPLING SIGNAL OF SECOND SIGNAL           │
└─────────────────────────────────────────────────┘
                        │
                        ▼
┌─────────────────────────────────────────────────┐
│   ADJUST IMPEDANCE OF SECOND CONDUCTIVE PORTION   │
│           OR THIRD CONDUCTIVE PORTION,            │ ── 806
│        VIA IMPEDANCE MATCHING CIRCUITRY           │
└─────────────────────────────────────────────────┘
```

FIG. 8D

FIG. 8E

FIG. 8F

FIG. 9

## INTERNATIONAL SEARCH REPORT

| International application No. |
| --- |
| **PCT/KR2023/014578** |

**A. CLASSIFICATION OF SUBJECT MATTER**

**H04M 1/02**(2006.01)i; **G06F 1/16**(2006.01)i; **H03H 7/38**(2006.01)i; **F16C 11/04**(2006.01)i; **H05K 1/02**(2006.01)i

According to International Patent Classification (IPC) or to both national classification and IPC

**B. FIELDS SEARCHED**

Minimum documentation searched (classification system followed by classification symbols)

H04M 1/02(2006.01); H01Q 1/08(2006.01); H01Q 1/24(2006.01); H01Q 1/36(2006.01); H01Q 1/38(2006.01); H01Q 23/00(2006.01); H04B 1/40(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 폴딩(folding), 도전성(conductivity), 프로세서(processor), 경로(path), 가장자리 (edge)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0046399 A (SAMSUNG ELECTRONICS CO., LTD.) 07 May 2020 (2020-05-07)<br>See paragraphs [0050]-[0103] and figures 5 and 6. | 1-15 |
| A | KR 10-2022-0105873 A (SAMSUNG ELECTRONICS CO., LTD.) 28 July 2022 (2022-07-28)<br>See paragraphs [0018]-[0099] and figures 4 and 6. | 1-15 |
| A | KR 10-2020-0100986 A (SAMSUNG ELECTRONICS CO., LTD.) 27 August 2020 (2020-08-27)<br>See paragraph [0310] and figure 7a. | 1-15 |
| A | CN 112736404 A (VIVO MOBILE COMMUNICATION CO., LTD.) 30 April 2021 (2021-04-30)<br>See paragraph [0038]. | 1-15 |
| A | CN 210006930 U (OPPO GUANGDONG MOBILE TELECOMMUNICATIONS CO., LTD.) 31 January 2020 (2020-01-31)<br>See paragraphs [0030] and [0031] and figure 6. | 1-15 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 January 2024** | **10 January 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT<br>Information on patent family members | | International application No.<br>**PCT/KR2023/014578** |
|---|---|---|

| Patent document<br>cited in search report | | | Publication date<br>(day/month/year) | Patent family member(s) | | | Publication date<br>(day/month/year) |
|---|---|---|---|---|---|---|---|
| KR | 10-2020-0046399 | A | 07 May 2020 | CN | 112956176 | A | 11 June 2021 |
| | | | | EP | 3855711 | A1 | 28 July 2021 |
| | | | | EP | 3855711 | A4 | 15 December 2021 |
| | | | | EP | 3855711 | B1 | 09 August 2023 |
| | | | | KR | 10-2545668 | B1 | 21 June 2023 |
| | | | | US | 11405493 | B2 | 02 August 2022 |
| | | | | US | 2021-0377372 | A1 | 02 December 2021 |
| | | | | WO | 2020-085791 | A1 | 30 April 2020 |
| KR | 10-2022-0105873 | A | 28 July 2022 | WO | 2022-158753 | A1 | 28 July 2022 |
| KR | 10-2020-0100986 | A | 27 August 2020 | CN | 113748663 | A | 03 December 2021 |
| | | | | EP | 3926935 | A1 | 22 December 2021 |
| | | | | EP | 3926935 | A4 | 06 April 2022 |
| | | | | US | 2022-0115768 | A1 | 14 April 2022 |
| | | | | WO | 2020-171580 | A1 | 27 August 2020 |
| CN | 112736404 | A | 30 April 2021 | None | | | |
| CN | 210006930 | U | 31 January 2020 | None | | | |

Form PCT/ISA/210 (patent family annex) (July 2022)